# EUROPEAN PATENT APPLICATION

(11) **EP 3 012 236 A1**
(43) Date of publication of application: **27.04.2016**
(21) Application number: 14813642.7
(22) Date of filing: 13.06.2014
(51) Int. Cl.: C03C 19/00, C03C 17/25, H01L 31/042

(54) **SOLAR CELL MODULE AND METHOD FOR PRODUCING SOLAR CELL MODULE**

(30) Priority: 17.06.2013 JP 2013127063
(71) Applicant: Kaneka Corporation, Osaka-shi, Osaka 530-8288 (JP)
(72) Inventor: SASAKI Toshiaki, Osaka-shi Osaka 530-8288 (JP); NAKATA Toshinobu, Osaka-shi Osaka 530-8288 (JP)
(74) Representative: Hoffmann Eitle
(86) International application number: PCT/JP2014/065741
(87) International publication number: WO 2014/203820

(57) **Abstract**

Provided is a solar cell module which has an anti-glare property and is capable of exhibiting a high antifouling property. A surface of a plate body made of glass in a solar cell module is roughened, and further, an antireflection film is laminated thereon. A change point at which the slope of the contour line of the surface is changed steeply is made to exist on a cross-section cutting through the plate body in the thickness direction. Where with the change point as a boundary, a straight line obtained by pseudo-leveling of the contour line existing within 0.7 micrometer on one side is a one-side pseudo-straight line and a straight line obtained by pseudo-leveling of the contour line existing within 0.7 micrometer on another side is an other-side pseudo-straight line, a steep slope portion in which an angle formed by the one-side pseudo-straight line and the other-side pseudo-straight line is 135 degrees or less, and a large crack having an opening width of 0.2 micrometer or more are distributed with the total number thereof being less than 5 per each 58-micrometer compartment range.

## Description

### TECHNICAL FIELD

The present invention relates to a solar cell module, and more particularly to a solar cell module having an anti-glare property and an antifouling property.

The present invention also relates to a method for producing a solar cell module having an anti-glare property and an antifouling property.

### BACKGROUND ART

In recent years, solar photovoltaic power generation systems that generate power by means of solar energy have rapidly spread. Such solar photovoltaic power generation systems include a system referred to as a roof installation type in which solar cell modules are installed on top of a building, and a system referred to as a wall surface installation type in which solar cell modules are installed on the wall surface or window of a building. Further, there is a system referred to as a ground installation type in which a solar cell module is installed on the outdoor ground.

In these types of solar photovoltaic power generation systems, there may be a problem caused by reflected light from the solar cell module depending on a position or angle at which the solar cell module is installed. For example, there is a problem that when a solar cell module is installed on the roof of a typical house, reflected light passes through the window of the neighboring house. That is, there is a problem that sunlight is regularly reflected at the glass surface of a solar photovoltaic power generation module, so that unintended intense light passes into the neighboring house to give an unpleasant feeling to neighborhood residents.

Thus, the development of a solar cell module having a high anti-glare property is desired. That is, the development of a solar cell module with reduced regular reflection from a glass surface in reception of sunlight is desired.

A solar cell module having an anti-glare property is disclosed in Patent Document 1. The solar cell module disclosed in Patent Document 1 has an antireflection film provided on a surface of a glass substrate.

Here, the antireflection film is a film which has an optical refractive index between the refractive index of air and the refractive index of glass, and in the solar cell module disclosed in Patent Document 1, reflection of light is suppressed by reducing a difference in the refractive index at each interface (air/antireflection film and antireflection film/glass) at which light is incident.

Patent Document 2 discloses a technology in which the surface of an antireflection film is roughened for the purpose of irregularly reflecting sunlight at the surface of a solar cell module.

According to the technology disclosed in Patent Document 2, an anti-glare property is enhanced due to the change in refractive index of the antireflection film, and in addition, light can be irregularly reflected due to the physically irregular structure on the surface, so that a higher anti-glare performance is exhibited.

However, for employing the technology disclosed in Patent Document 2, it is necessary to form an antireflection film with a considerable thickness, leading to the problem that the light absorption of the anti-glare film itself increases and deteriorates power generation efficiency.

An invention for solving these problems is disclosed in Patent Document 3.

In the invention disclosed in Patent Document 3, the surface of a glass substrate is subjected to blast processing to roughen the surface, and further, an antireflection film is provided thereon.

### PRIOR ART DOCUMENT

### PATENT DOCUMENT

Patent Document 1: JP 8-211202 A
Patent Document 2: JP 2001-57438 A
Patent Document 3: JP 2012-9600 A

### DISCLOSURE OF INVENTION

### TECHNICAL PROBLEM

Although the solar cell modules described in Patent Documents 2 and 3 are excellent in anti-glare performance, they have the disadvantage of being easily stained.

That is, in the solar cell module described in Patent Document 2, the surface of an antireflection film is roughened, and therefore once dirt or dust is caught in the roughened portion, the dirt or dust is difficult to remove from the surface. In other words, the surface of the solar cell module is easily stained.

In the solar cell module described in Patent Document 3, the surface of a glass substrate is provided with irregularities, which are covered with an antireflection film, but since the antireflection film is generally thin, the irregularities on the base (glass substrate) appear as they are on the surface of the antireflection film. Therefore, once dirt or dust is caught in the irregularity portion, the dirt or dust is difficult to remove from the surface.

In roof installation type solar cell systems and ground installation type solar cell systems, the solar cell module is installed in an inclined attitude so as to receive as much sunlight as possible. Particularly, a solar cell module to be installed on a roof of a Japanese house is generally installed in an inclined attitude conforming to the inclination of the roof.

Here, in Japan, yellow sand comes flying in from China, mainly at the beginning of spring. In roof installation type solar cell systems and ground installation type solar cell systems, the problem arises that the yellow sand which has come flying in is deposited on the solar cell module because the solar cell module is installed in an inclined attitude.

That is, although rain washes away most of the yellow sand, a solar cell module having an improved anti-glare property has fine irregularities on a surface thereof, so that the yellow sand is not easily washed away, leading to deterioration of power generation efficiency of the solar cell. The appearance is also deteriorated.

Solar cell modules have been spreading rapidly not only in Japan but also overseas. Solar cell modules are expected to spread in the future in the countries of the Middle and Near East such as Saudi Arabia.

However, when the solar cell module is installed in a country where most of the nation's land is constituted by desert, the power output may be reduced under the influence of dust. That is, there may be a problem that the sand which has come flying in is deposited on the solar cell module to reduce the power output of the solar cell module.

Thus, in view of the above-mentioned problems of the conventional technologies, an object of the present invention is to provide a solar cell module which not only exhibits a high anti-glare property, but also is stain-resistant. Also, an object of the present invention is to provide a method for producing a solar cell module, the method being intended to produce the above-mentioned solar cell module.

### SOLUTION TO PROBLEM

For solving the problems described above, the present inventors experimentally produced a solar cell module as described in Patent Document 3, and observed its surface shape and cross-sectional shape. The results showed that in the solar cell module described in Patent Document 3, a large number of cracks existed on the surface of a glass plate, an antireflection film was laminated on the cracks, and the same irregular shape associated with the cracks appeared on the antireflection film.

Specifically, in the solar cell module disclosed in Patent Document 3, the glass substrate is subjected to blast processing to roughen the surface thereof. Here, blast processing is a surface treatment process in which fine abrasive particles are collided against a work piece to polish the surface thereof, and therefore in blast processing, the surface of the glass substrate is struck. Consequently, fine cracks are generated in the glass substrate.

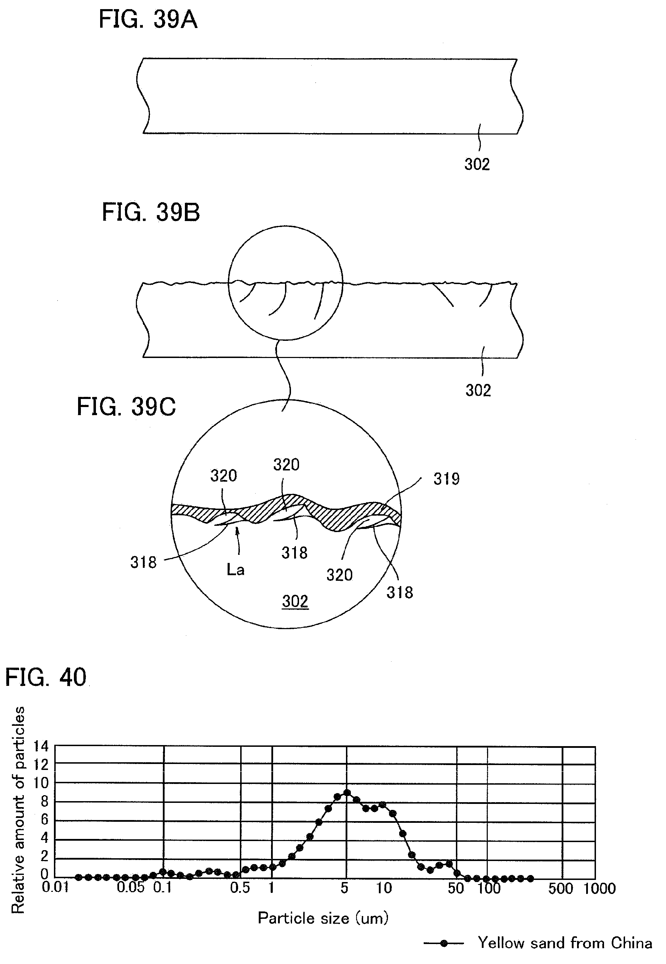

That is, in the solar cell module produced using the technology disclosed in Patent Document 3, a blasting abrasive material is collided against a glass substrate 302 having a smooth surface as shown in Fig. 39A, so that the surface is roughened as shown in Fig. 39B, but the impact of the collision causes generation of cracks 318 as shown in an enlarged view of Fig. 39C.

That is, an insufficiently impacted portion comes into a cracked state with an undivided portion 320 generated as shown in Fig. 39C. Cracks 318 include fissures developing in a depth direction of the glass substrate 302, and fissures developing in a direction parallel to the glass substrate 302 (diverse cracks are not illustrated in Fig. 39). In the vicinity of the portion in which the crack 318 with a fissure developing in a direction parallel to the glass substrate 302 is formed, a fragment sticks in a scale-like form to a main body part of the glass substrate 302.

Accordingly, the portion of the crack 318 has a stepped shape in which the slope of a contour line Lα forming a boundary between the glass substrate 302 and an antireflection film 319 changes steeply.

The present inventors scattered a fine powder over the glass substrate of the solar cell module produced using the technology disclosed in Patent Document 3. Further, one side of the solar cell module was then lifted, the solar cell module was erected in the state of being inclined with respect to the ground surface, and the vicinity of the surface of the solar cell module was observed. As a result, it was found that sand grains were caught in a stepped-shape portion formed at the portion of the crack in the glass substrate, i.e. a portion having a stepped shape with the contour line changing steeply.

The vicinity of the crack portion looked really fragile because a fragment stuck in a scale-like form to the main body part of the glass substrate as described above.

Thus, the present inventors performed blast processing to provide irregularities on the surface, and then performed blast processing again using a blasting abrasive material having a smaller particle size as compared to the previous blast processing. That is, a light impact, which would not damage the main body part of the glass substrate, was applied. As a result, cracks in the glass substrate were removed, portions with the contour line changing steeply were considerably reduced, and portions having a stepped shape were also reduced.

After the blast processing was performed twice, an antireflection film was formed. Resultantly, internal spaces of remaining cracks and depressions of stepped-shape portions were filled with the antireflection film, so that a generally smooth surface was formed.

The solar cell module, which was subjected to blast processing twice and then provided with an antireflection film, was evaluated, and the results showed that the solar cell module was considerably excellent in the antifouling property while being comparable in the anti-glare property and power generation efficiency to that disclosed in Patent Document 3.

The present inventors examined influences of deposition of yellow sand on the glass substrate.

Results of studies on the particle size of the yellow sand are disclosed on SHIMADZU CORPORATION's website (http://www.an.shimadzu.co.jp/powder/lecture/beginner/b03.htm). Fig. 40 is a graph cited from the website.

According to the studies, the particle size of yellow sand comes flying to Japan is distributed with a size of 5 micrometers as a peak. The graph shows that most of the yellow sand comes flying to Japan has a particle size of 1 micrometer or more. Some extremely fine particles of 0.5 to 1.0 micrometer are included. The amount of yellow sand having a particle size of less than 0.5 micrometer is extremely low.

Not all yellow sand particles have a spherical shape. Instead, many yellow sand particles have a shape similar to a rice grain.

Other data shows that fine sand and medium sand having a particle size of 0.2 to 0.4 mm are common in the Rub' al Khali in the Kingdom of Saudi Arabia, and the deserts of this country are abundant in rounded medium sand with a particle size of about 0.5 mm, which is accompanied by fine particles with a particle size of 0.1 to 0.3 mm. However, it is evident that a sandstorm generated in the Middle East also includes considerably fine particles.

An invention completed based on these findings provides a solar cell module including a glass plate body made of glass and having a macroscopically flat surface, and a photoelectric conversion unit, the solar cell module generating electricity in the photoelectric conversion unit by making light incident from a glass plate body side to a photoelectric conversion unit side,
wherein the surface of the glass plate body is provided with an antireflection film and is itself microscopically irregular, the surface of the glass plate body having a change point at which a slope on a contour line of the surface of the glass plate body changes steeply when a cross-section cutting through the glass plate body in a thickness direction is observed, a steep slope portion in which the glass plate body itself is recessed and an angle formed by a one-side pseudo-straight line obtained by pseudo-leveling of the contour line within 0.7 micrometer on one side and an other-side pseudo-straight line obtained by pseudo-leveling of the contour line within 0.7 micrometer on another side with the change point as a boundary is 135 degrees or less, and a large crack having an opening width of 0.2 micrometer or more,
some or all of the steep slope portion and some or all of the large crack of the surface of the glass plate body itself are filled with a substance that forms the antireflection film, and
a surface of the antireflection film has a contour line of a gentle curve, the surface of the antireflection film having a total number of less than 5 steep slope portions and large cracks per each 58-micrometer compartment range at the surface of the antireflection film.

Another invention for solving the same problems provides a solar cell module including a glass plate body made of glass and having a macroscopically flat surface, and a photoelectric conversion unit, the solar cell module generating electricity in the photoelectric conversion unit by making light incident from a glass plate body side to a photoelectric conversion unit side,
wherein the surface of the glass plate body is provided with an antireflection film and is itself microscopically irregular, the surface of the glass plate body having a steep slope portion in which the glass plate body itself is recessed when a cross-section cutting through the glass plate body in a thickness direction is observed and an angle formed by a one-side pseudo-straight line obtained by pseudo-leveling of the contour line within 0.7 micrometer on one side and an other-side pseudo-straight line obtained by pseudo-leveling of the contour line within 0.7 micrometer on another side with an arbitrary point as a boundary is 135 degrees or less, and a large crack having an opening width of 0.2 micrometer or more,
some or all of the steep slope portion and some or all of the large crack of the surface of the glass plate body itself are filled with a substance that forms the antireflection film, and
a surface of the antireflection film has a contour line of a gentle curve, the surface of the antireflection film having a total number of less than 5 steep slope portions and large cracks per each 58-micrometer compartment range at the surface of the antireflection film.

Preferably, the surface of the glass plate body itself has an overhang portion in which the angle formed by the one-side pseudo-straight line obtained by pseudo-leveling of the contour line within 0.7 micrometer on one side and the other-side pseudo-straight line obtained by pseudo-leveling of the contour line within 0.7 micrometer on the other side with the change point or an arbitrary point as a boundary is 90 degrees or less,
some or all of the overhang portions of the surface of the glass plate body itself are filled with a substance that forms the antireflection film, and
the surface of the antireflection film has a contour line of a gentle curve, the surface of the antireflection film having a total number of less than 2 steep slope portions and large cracks per each 58-micrometer compartment range at the surface of the antireflection film.

Still another invention for achieving the same object provides a solar cell module including a glass plate body made of glass and having a macroscopically flat surface and a photoelectric conversion unit, the solar cell module generating electricity in the photoelectric conversion unit by making light incident from a glass plate body side to a photoelectric conversion unit side,
wherein the surface of the glass plate body is provided with an antireflection film and is itself microscopically irregular, the surface of the glass plate body having a change point at which a slope on a contour line of the surface of the glass plate body changes steeply when a cross-section cutting through the glass plate body in a thickness direction thereof is observed, a steep slope portion in which the glass plate body itself is recessed and an angle formed by a one-side pseudo-straight line obtained by pseudo-leveling of the contour line within 0.7 micrometer on one side and an other-side pseudo-straight line obtained by pseudo-leveling of the contour line within 0.7 micrometer on another side with the change point as a boundary is 135 degrees or less, and a large crack having an opening width of 0.2 micrometer or more, the surface of the glass plate body itself having a total number of less than 5 steep slope portions and the large cracks with per each 58-micrometer compartment range at the surface thereof, and some or all of the steep slope portion is filled with a substance forming the antireflection film that has a contour line of a gentle curve.

Still another invention for achieving the same object provides a solar cell module including a glass plate body made of glass and having a macroscopically flat surface, and a photoelectric conversion unit, the solar cell module generating electricity in the photoelectric conversion unit by making light incident from a glass plate body side to a photoelectric conversion unit side,
wherein the surface of the glass plate body is provided with an antireflection film and is itself microscopically irregular, the surface of the glass plate body having a steep slope portion in which the glass plate body itself is recessed when a cross-section cutting through the glass plate body in a thickness direction thereof is observed and an angle formed by a one-side pseudo-straight line obtained by pseudo-leveling of the contour line within 0.7 micrometer on one side and an other-side pseudo-straight line obtained by pseudo-leveling of the contour line within 0.7 micrometer on another side with an arbitrary point as a boundary is 135 degrees or less, and a large crack having an opening width of 0.2 micrometer or more, the surface of the glass plate body itself having a total number of less than 5 steep slope portions and large cracks per each 58-micrometer compartment range at the surface thereof, and some or all of the steep slope portions are filled with a substance forming the antireflection film that has a contour line of a gentle curve.

Preferably, the surface of the glass plate body itself has an overhang portion in which the angle formed by the one-side pseudo-straight line obtained by pseudo-leveling of the contour line within 0.7 micrometer on one side and the other-side pseudo-straight line obtained by pseudo-leveling of the contour line within 0.7 micrometer on the other side with the change point or an arbitrary point as a boundary is 90 degrees or less, the surface of the glass plate body itself having a total number of less than 2 steep slope portions and large cracks per each 58-micrometer compartment range at the surface thereof, and some or all of the overhang portions of the surface of the glass plate body itself are filled with a substance that forms the antireflection film.

Preferably, an average value of the total number of the steep slope portions and the large cracks per each 58-micrometer compartment range is 0.5 or more and less than 5 at the surface of the antireflection film.

Preferably, an average value of the total number of the steep slope portions and the large cracks per each 58-micrometer compartment range is 0.5 or more and less than 5 at the surface of the glass plate body itself.

Preferably, a glass surface high level-difference portion having an elevation difference of 0.7 micrometer or more per 0.3 micrometer at the surface of the glass plate body itself is distributed with a number thereof being 3 or less per each 58-micrometer compartment range, and a film surface high level-difference portion having an elevation difference of 0.7 micrometer or more per 0.3 micrometer at the surface of the antireflection film is distributed with a number thereof being less than 1 per each 58-micrometer compartment range.

That is, it is preferable that when a measurement is made over the range of 0.3 micrometer in parallel to the macroscopically flat surface, film surface high level-difference portions having a height change of 0.7 micrometer or more within this range are distributed with the number thereof being less than 1 per 58-micrometer compartment range.

Preferably, a glass surface high level-difference portion having an elevation difference of 0.3 micrometer or more per 0.3 micrometer at the surface of the glass plate body itself is distributed with a number thereof being 7 or less per 58-micrometer compartment range, and a film surface high level-difference portion having an elevation difference of 0.3 micrometer or more per 0.3 micrometer at the surface of the antireflection film is distributed with a number thereof being less than 3 per 58-micrometer compartment range.

In the solar cell modules of these inventions, the glass plate body is microscopically irregular, but there are a few locations at which yellow sand is caught. That is, as described above, most of the yellow sand comes flying to Japan has a particle size of 1.0 micrometer or more. Therefore, it suffices that the measure against yellow sand targets yellow sand having a particle size of 1.0 micrometer or more.

Here, irregularities in which yellow sand can be caught include depressions, cracks and high level differences. The depression is recessed portion, and has a relatively small depth. The depression has a wider opening angle as compared to a crack. Therefore, only depressions having a narrow opening angle and a measurable level difference and depth catch yellow sand, and depressions having a low level difference and height or portions having a wide opening angle cause sand grains to roll down even though getting yellow sand.

Here, given the fact that most of sand grains of yellow sand have a particle size of 1.0 micrometer or more, the yellow sand comes flying to Japan settles in a portion which is a steeply changing slope portion having a length just more than half of the particle size of yellow sand and held by the wall surface, and has a narrow opening angle. Specifically, considering a length of 0.7 micrometer with a reference point as a boundary, the yellow sand settles in a portion having a steeply changed angle or having a largely depressed cross-sectional shape within this length.

The crack has an extremely small opening angle, and is deep. On the other hand, more than few yellow sand particles have a rice-grain-like shape rather than a spherical shape. Therefore, the short diameter of yellow sand is equal to or less than half of the particle size that is the long diameter. Therefore, yellow sand sticks in a crack having an opening width of 0.2 micrometer or more, and cannot be removed.

Yellow sand does not get stuck in an ordinary level difference, but yellow sand is not easily washed away by rain when the level difference is high. When yellow sand wetted by rain settles, and in this settled state, the rain evaporates, the yellow sand cannot be removed.

Given the fact that most of sand grains of yellow sand have a particle size of 1.0 micrometer or more as described above, yellow sand settles in level differences of 0.7 micrometer or more.

Therefore, when the number of level differences of 0.7 micrometer or more is small, yellow sand does not easily settle.

Fine yellow sand easily forms a lump after rain water evaporates.

As described above, extremely fine particles of 0.5 to 1.0 micrometer are slightly included in yellow sand comes flying to Japan. The ratio of yellow sand having a particle size of less than 0.5 micrometer is extremely low.

Given this fact, extremely fine particles having a particle size of 0.5 to 1.0 micrometer may be accumulated in a level difference of 0.3 micrometer or more. Therefore, when the number of level differences of 0.3 micrometer or more is small, yellow sand does not form a lump.

The solar cell module of the present invention has a small total number of steep slope portions and large cracks in which yellow sand may settle. Further, the steep slope portions in which yellow sand may settle are filled with a substance that forms the antireflection film, and the contour line of the surface draws a gentle curve. Therefore, yellow sand deposited on the solar cell module is removed by wind or rain, and thus the solar cell module not only has a good appearance but also maintains high power generation non-efficiency over a long period of time.

The solar cell modules of the present invention also have a high anti-glare property because the surface of the glass plate body is microscopically irregular, and further, an antireflection film is provided on the surface of the glass plate body.

That is, the solar cell module of the present invention can have an improved antifouling property while maintaining an anti-glare property.

Specifically, if irregularities on the light-incident surface of the solar cell module are completely eliminated, reflected light is not dispersed, and thus the anti-glare property is deteriorated. On the other hand, when a large number of irregularity portions having a steep slope are formed, sand grains, etc., are caught in the portions. Thus, in the present invention, the number of steep slope hole portions that are irregularity portions having a steep slope is limited within the above-mentioned range to achieve maintenance of the anti-glare property and improvement of the antifouling property. That is, the solar cell module has a structure in which reflected light is sufficiently dispersed, and sand grains of yellow sand and dust do not easily remain on the surface.

In the present invention, a 58-micrometer compartment range is set as a reference. Here, the size of the compartment "58 micrometers" does not have a significant meaning, and is merely defined as a range which is easily confirmed by a commercially available testing apparatus. Therefore, if a double-size range, i.e. a 116-micrometer range can be confirmed, the number of steep slope portions, etc., proportionally increases.

In the present invention, the portion in which "the contour line is gentle" is a portion in which when any one point on the contour line that forms the portion is set as a reference point, an angle formed by a one-side pseudo-straight line obtained by pseudo-leveling of the contour line within 0.7 micrometer on one side and an other-side pseudo-straight line obtained by pseudo-leveling of the contour line within 0.7 micrometer on the other side with the reference point as a boundary is 135 degrees or more. More preferably, the portion is a portion in which the formed angle is 150 degrees or more.

Here, in an area where steep slope portions, large cracks, and overhang portions are filled, the thickness of the antireflection film is larger as compared to other areas. More specifically, it is preferable that the thickness of the antireflection film in the area where steep slope portions, large cracks, and overhang portions are filled is larger than the average value of the thickness in the whole of the antireflection film by 30 percent or more. That is, the thickness of the antireflection film in the area is larger than the average of the thickness in the whole of the antireflection film.

Preferably, the surface of the antireflection film has an arithmetic mean deviation of 0.4 micrometer to 2.0 micrometers.

An invention relating to a method for producing these solar cell modules provides a method for producing a solar cell module, including a first roughening step of colliding solid particles to the surface of the glass plate body to roughen the surface of the glass plate body; a second roughening step of colliding solid particles, which have a particle size smaller than that in the first roughening step, to the surface of the glass plate body after the first roughening step; and an antireflection film forming step of applying a liquid antireflection film raw material to the surface of the glass plate body to form the antireflection film on the surface of the glass plate body.

Another invention relating to a method for producing a solar cell module provides a method for producing a solar cell module, the solar cell module comprising a glass plate body made of glass and having a macroscopically flat surface, and a photoelectric conversion unit, the solar cell module generating electricity in the photoelectric conversion unit by making light incident from the glass plate body side to the photoelectric conversion unit side, the method including:
a first roughening step of colliding solid particles to the surface of the glass plate body to roughen the surface of the glass plate body;
a second roughening step of colliding solid particles, which have a particle size smaller than that in the first roughening step, to the surface of the glass plate body after the first roughening step; and
an antireflection film forming step of applying a liquid antireflection film raw material to the surface of the glass plate body to form an antireflection film on the surface of the glass plate body.

In the present invention, blast processing is performed twice as described above. Here, in the first roughening step, a blasting abrasive material having a large particle size is used, and therefore a strong impact is given to the glass substrate, so that the surface of the plate body is picked to form an irregular shape. However, a large number of cracks are generated as described above.

Thus, in the production method of the present invention, the second roughening step is carried out to remove many of the cracks generated in the first roughening step.

That is, in the second roughening step, a blasting abrasive material having a particle size smaller than that in the first roughening step is used. Therefore, in the second roughening step, the capability of roughening the surface of the plate body is low, but a capability of rupturing portions having low rigidity is exhibited. Therefore, crack portions having low rigidity are ruptured, and resultantly, the number of irregularity portions formed in the vicinity of the crack portions and having a steep slope is reduced.

It is recommended that the abrasive material to be used in the first roughening step have a size in a range of #40 to #600 in terms of a nominal count.

It is recommended that the abrasive material to be used in the second roughening step have a size in a range of #400 to #3000 in terms of a nominal count.

It is recommended that white alumina be used in the abrasive material.

### EFFECT OF THE INVENTION

According to the present invention, there can be provided a solar cell module which exhibits a high anti-glare property and which is excellent in antifouling property.

### BRIEF DESCRIPTION OF THE DRAWINGS

Fig. 1 is a partially cutaway perspective view showing a solar cell module according to an embodiment of the present invention.
Figs. 2A to 2G are explanatory views showing a photoelectric conversion unit production step carried out before a surface treatment in a step of producing the solar cell module in Fig. 1. The solar cell module is formed in the order of Fig. 2A to Fig. 2G.
Figs. 3A to 3C are schematic views conceptually showing a glass substrate of a solar cell module, where Fig. 3A is an enlarged sectional view; Fig. 3B is an enlarged cross-sectional view of Fig. 3A; and Fig. 3C is an enlarged cross-sectional view in which Fig. 3B is further enlarged.
Fig. 4A is an enlarged view of one depression portion of a glass plate body; and Fig. 4B is an explanatory view with an additional line drawn in Fig. 4A.
Fig. 5A is an enlarged view of another depression portion of the glass plate body; and Fig. 5B is an explanatory view with an additional line drawn in Fig. 5A.
Fig. 6A is an enlarged view of still another depression portion of the glass plate body; and Fig. 6B is an explanatory view with an additional line drawn in Fig. 6A.
Fig. 7A is an enlarged view of still another depression portion of the glass plate body; and Fig. 7B is an explanatory view with an additional line drawn in Fig. 7A.
Fig. 8 is an enlarged view of a crack portion of the glass plate body.
Fig. 9A is an enlarged view of still another depression portion of the glass plate body; and Fig. 9B is an explanatory view with an additional line drawn in Fig. 9A.
Fig. 10 is a schematic view conceptually showing a glass substrate of a solar cell module according to an embodiment of the present invention, where an enlarged view is shown in each circle.
Figs. 11A to 11C are explanatory views conceptually showing the vicinity of a light-incident surface of a solar cell module formed by a conventional technology, where Fig. 11A is a sectional view of the vicinity of a light-incident surface; Fig. 11B is an enlarged view of Fig. 11A; and Fig. 11C is a partial enlarged view in which a part of Fig. 11B is further enlarged.
Figs. 12A to 12C are schematic views conceptually showing the solar cell module formed by the conventional technology, where Fig. 12A is an enlarged plan view; Fig. 12B is an A-A sectional view of Fig. 12A; and Fig. 12C is an enlarged sectional view in which Fig. 12B is further enlarged.
Fig. 13 is an explanatory view showing a state in which crack portions shine in the solar cell module formed by the conventional technology.
Figs. 14A to 14C are schematic views conceptually showing a glass substrate of a solar cell module according to an embodiment of the present invention, with the number and size of cracks being exaggerated, where Fig. 14A is an enlarged plan view; Fig. 14B is an A-A sectional view of Fig. 14A; and Fig. 14C is an enlarged sectional view in which Fig. 14B is further enlarged.
Fig. 15 is an explanatory view showing the crack portions of Fig. 14A in an enlarged form.
Fig. 16 is an explanatory view showing a state in which crack portions shine white in a solar cell module according to an embodiment of the present invention.
Figs. 17A to 17B are views showing the vicinity of a light-incident surface of a solar cell module according to Example 1 in the present invention, where Fig. 17A is a photograph showing an SEM image; and Fig. 17B shows a trace diagram of Fig. 17A.
Fig. 18 is a trace diagram in which the vicinity of the light-incident surface in Fig. 17 is further enlarged.
Figs. 19A and 19B are views showing a portion different from that in Fig. 17 in the vicinity of the light-incident surface of the solar cell module according to Example 1 in the present invention, where Fig. 19A is a photograph showing a SEM image; and Fig. 19B shows a trace diagram of Fig. 19A.
Fig. 20 is a trace diagram in which the vicinity of the light-incident surface in Fig. 19 is further enlarged.
Figs. 21A and 21B are views showing a portion different from those in Figs. 17 and 19 in the vicinity of the light-incident surface of the solar cell module according to Example 1 in the present invention, where Fig. 21A is a photograph showing a SEM image; and Fig. 21B shows a trace diagram of Fig. 21A.
Fig. 22 is a trace diagram in which the vicinity of the light-incident surface in Fig. 21 is further enlarged.
Figs. 23A and 23B are reference photographs showing a state in which an antifouling property test is conducted for the solar cell module according to Example 1 in the present invention and the solar cell module formed by the conventional technology, where Fig. 23A shows an experiment in which stains deposited by scattering sand are removed; and Fig. 23B shows an experiment in which stains deposited by a pencil and an oil-based pen are removed.
Figs. 24A and 24B are graphs showing the results of measuring the strength of each of an anti-glare glass plate subjected to steps according to Example 1 in the present invention and a usual glass plate, where Fig. 24A corresponds to the usual glass plate; and Fig. 24B corresponds to the anti-glare glass plate.
Fig. 25 is a graph showing the results of comparing the regular reflectance of the solar cell module according to Example 1 in the present invention with the regular reflectance of each of the solar cell modules formed by the conventional technology and commercially available roof materials.
Figs. 26A and 26B are reference photographs of a solar cell module according to Example 2 in the present invention and the solar cell module formed by the conventional technology obtained by photographing in daytime natural light, with the photographs 26A and 26B taken at different locations.
Fig. 27 is an optical image showing a surface of a glass substrate after the first roughening step.
Fig. 28 is an optical image showing the surface of the glass substrate after the first roughening step and the second roughening step are sequentially carried out.
Fig. 29 is an optical image showing the surface of the glass substrate after the first roughening step and the second roughening step are sequentially carried out, and further an antireflection film is formed.
Figs. 30A and 30B are views showing the vicinity of a light-incident surface of a solar cell module according to Comparative Example 1, where Fig. 30A is a photograph showing an SEM image; and Fig. 30B shows a trace diagram of Fig. 30A.
Fig. 31 is a trace diagram in which the vicinity of the light-incident surface in Fig. 30 is further enlarged, with a steep slope portion shown in an enlarged form.
Fig. 32 is a trace diagram in which the vicinity of the light-incident surface in Fig. 30 is further enlarged, with a large crack shown in an enlarged form.
Figs. 33A and 33B are views showing a portion different from that in Fig. 30 in the vicinity of the light-incident surface of the solar cell module according to Comparative Example 1, where Fig. 33A is a photograph showing a SEM image; and Fig. 33B shows a trace diagram of Fig. 33A.
Fig. 34 is a trace diagram in which the vicinity of the light-incident surface in Fig. 33 is further enlarged, with a steep slope portion shown in an enlarged form.
Fig. 35 is a trace diagram in which the vicinity of the light-incident surface in Fig. 33 is further enlarged, with a large crack shown in an enlarged form.
Figs. 36A and 36B are views showing a portion different from those in Figs. 30 and 33 in the vicinity of the light-incident surface of the solar cell module according to Comparative Example 1, where Fig. 36A is a photograph showing an SEM image; and Fig. 36B shows a trace diagram of Fig. 36A.
Fig. 37 is a trace diagram in which the vicinity of the light-incident surface in Fig. 36 is further enlarged, with a steep slope portion shown in an enlarged form.
Fig. 38 is a trace diagram in which the vicinity of the light-incident surface in Fig. 36 is further enlarged, with a large crack shown in an enlarged form.
Figs. 39A to 39C are schematic views conceptually showing the glass substrate of the solar cell module formed by the conventional technology, where Fig. 39A is a macroscopic sectional view; Fig. 39B is a sectional view in which Fig. 39A is further enlarged; and Fig. 39C is a sectional view in which Fig. 39B is further enlarged.
Fig. 40 is a graph showing a particle size distribution of yellow sand which comes flying to Japan.

### MODES FOR CARRYING OUT THE INVENTION

Hereinafter, a solar cell module 1 of the present invention will be conceptually described.

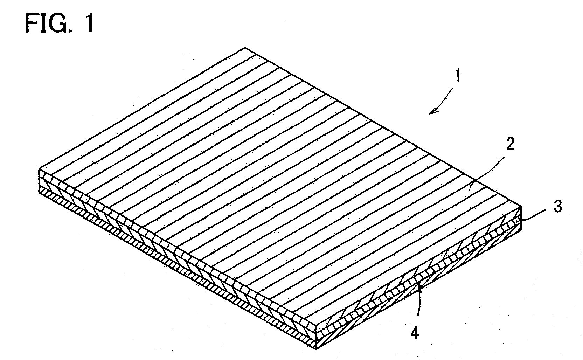

The solar cell module 1 of this embodiment is referred to as a thin-film-type solar cell module, and has a photoelectric conversion unit 3 laminated on the back surface side of a glass substrate 2 as shown in Fig. 1.

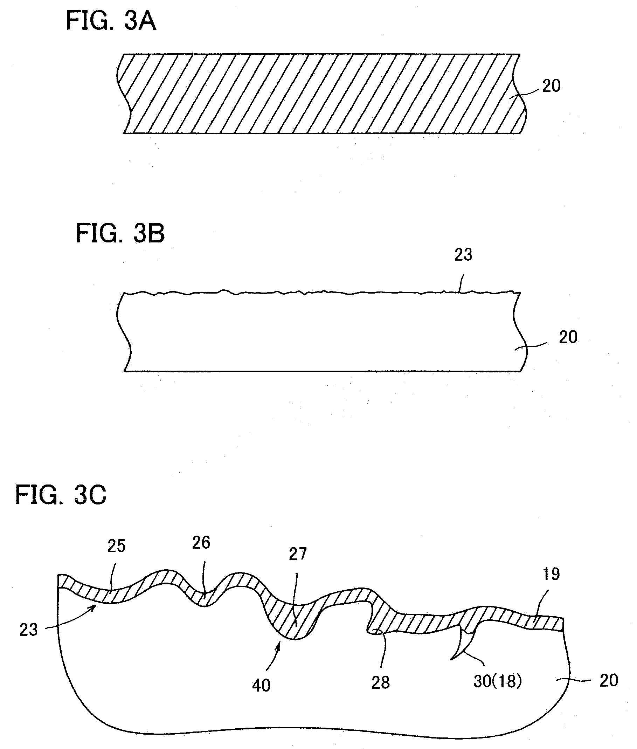

The glass substrate 2 includes as a base a glass plate body 20 made of glass and having a macroscopically flat surface, and on the surface of the glass plate body, an antireflection film 19 is laminated as in Fig. 3C.

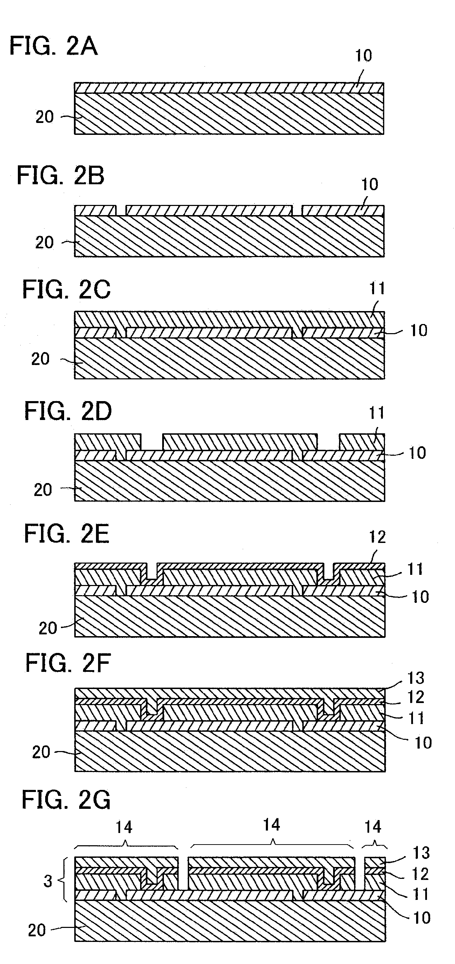

The photoelectric conversion unit 3 is formed by laminating a transparent electrode layer 10, a semiconductor thin-film photoelectric conversion layer 11, a back transparent electrode layer 12, and a back metal electrode layer 13 (see Fig. 2).

Further, in this embodiment, a back sheet 4 is provided on the rear surface (surface situated on the lower side in Fig. 1) side of the photoelectric conversion unit 3 as shown in Fig. 1.

In the solar cell module 1 of this embodiment, electricity is produced by making light incident from the surface side of the glass substrate 2 to the photoelectric conversion unit 3 side. That is, one surface of the glass substrate 2 forms a light-incident surface of the solar cell module 1.

The glass substrate 2 employed in this embodiment includes as a base the glass plate body 20 as described above, and on the surface of the glass plate body, the antireflection film 19 is laminated as in Fig. 3C.

Therefore, when the glass plate body 20 is macroscopically observed, its surface is a smooth surface as shown in Fig. 3A, but when the glass plate body 20 is microscopically observed, its surface is roughened and has a fine irregular shape 23 as in Fig. 3B. That is, as shown in Fig. 3B, the surface of the glass plate body 20 is physically processed into an irregular shape intentionally.

The irregular shape 23 on the surface of the glass plate body 20 includes various kinds of shapes, which include those having a depth or a shape that allows the yellow sand to settle.

Hereinafter, a definition for specifying the irregular shape 23 will be described with reference to Figs. 3 to 9. When the antireflection film 19 is laminated on the surface of the glass plate body 20, an irregular shape different from that on the surface of the glass plate body 20 is formed on the surface of the antireflection film 19. However, a definition for specifying the irregular shape formed on the surface of the antireflection film 19 is similar to the definition for specifying the irregular shape 23 on the surface of the glass plate body 20, and therefore duplicate descriptions are omitted.

First, when attention is paid to a cross-section cutting through the glass substrate 2 in the thickness direction, a contour line 40 of the surface of the glass plate body 20 itself has the irregular shape 23 as in Fig. 3B. Shapes in the irregular shape 23 are classified broadly into depressions 25, 26, 27, and 28 and a crack 18 as in Fig. 3C. The depressions 25, 26, 27, and 28 are portions shaved by a blast treatment as described later, and is shallow. The depressions have a wide opening angle. In the depressions 25, 26, 27, and 28, the bottommost position is clearly recognized.

The depressions 25, 26, 27, and 28 include cone-shaped depressions 25, 26, and 27 and an overhang-shaped depression 28. The depressions 25, 26, 27, and 28 are merely formed as portions to which particles of an abrasive material collided and have been ruptured and lost.

On the other hand, the crack 18 is a portion cracked by collision of particles of an abrasive material thereto. Therefore, the crack has a narrow opening angle, and is deep. The bottommost position is not clear.

The irregular shape 23 (depressions 25, 26, 27, and 28 and crack 18) include shapes in which the yellow sand is easily accumulated, and shapes in which the yellow sand is not easily accumulated. In the case of the depressions 25, 26, 27, and 28, the yellow sand is accumulated only when the depression is deep, and has a steep slope.

On the other hand, in the case of the crack 18, yellow sand is accumulated when the crack has a large opening width.

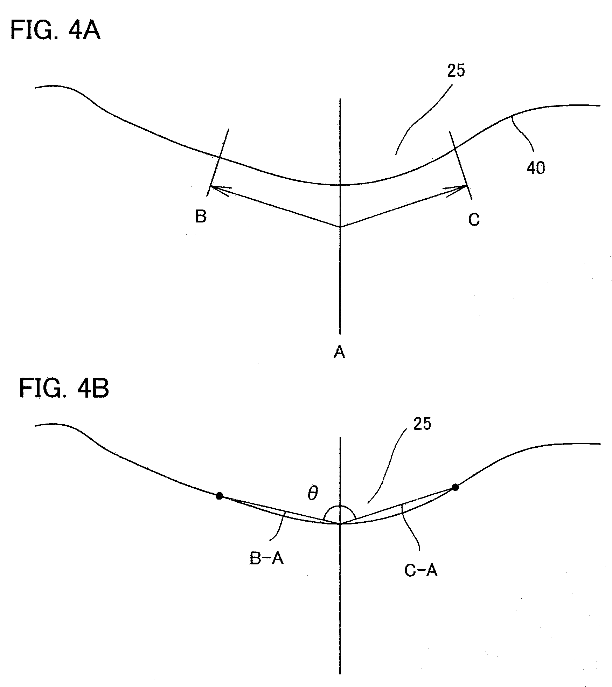

For evaluating the depressions 25, 26, 27, and 28, attention is given to the contour line 40 of the surface of the glass plate body 20 itself, and a change point A at which the slope changes steeply is specified as shown in, for example, Fig. 4. Left and right reference points B and C that are 0.7 micrometer away from the change point A along the average line of the contour line 40 are specified. An average straight line B-A between the change point A and the left reference point B is drawn. Similarly, an average straight line C-A between the change point A and the right reference point C is drawn. An angle θ formed by the straight line B-A and the straight line C-A is measured. The average straight lines B-A and C-A are straight lines obtained by pseudo-leveling of the contour line 40.

Here, a portion with the angle θ being less than 135 degrees is a steep slope portion, and yellow sand is accumulated therein. On the other hand, a portion with the angle θ being 135 degrees or more is a gentle slope portion, and yellow sand is not accumulated therein.

For explaining the depressions 25, 26, 27, and 28, in the depression 25, the left and right reference points B and C exist substantially within the curved surface of the recessed portion, but the angle 0 is 135 degrees or more as shown in Fig. 4, so that yellow sand is not accumulated. That is, the depression 25 has a gentle slope, and therefore causes the yellow sand to roll down, so that the yellow sand does not easily accumulate.

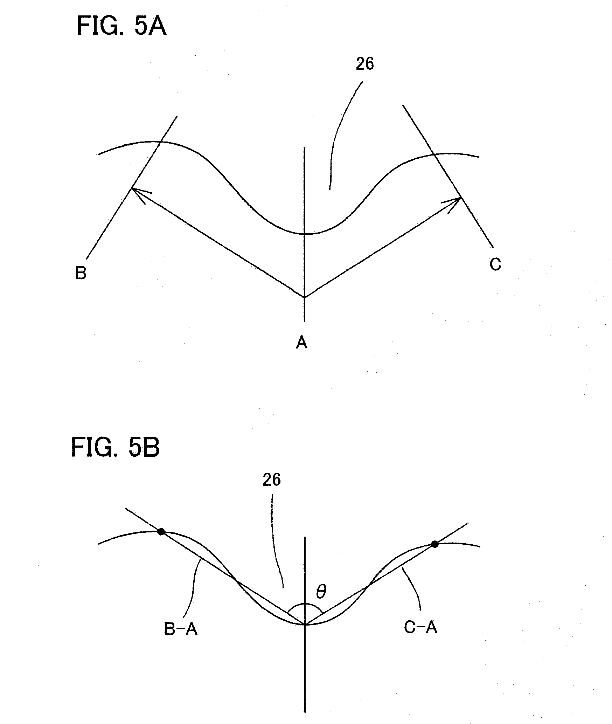

With regard to the depression 26, in the depression 26, the left and right reference points B and C exist substantially outside the recessed portion and the angle θ is 135 degrees or more as shown in Fig. 5, so that the yellow sand is not accumulated. That is, the depression 26 is shallow, and thus the yellow sand rolls over the depression 26.

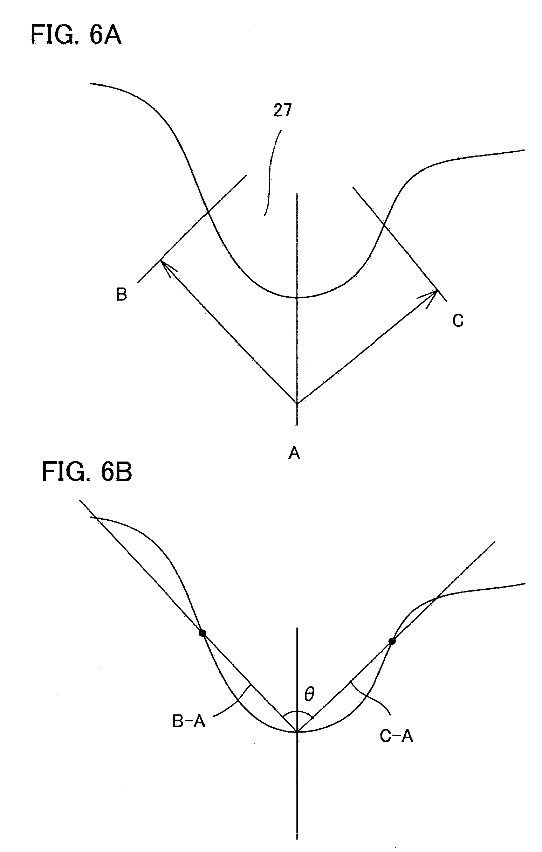

With regard to the depression 27, the left and right reference points B and C exist substantially within the curved surface of the recessed portion and the angle θ is less than 135 degrees as shown in Fig. 6, so that yellow sand is accumulated. That is, the depression 27 is deep and large, and therefore the yellow sand sticks therein. Further, the depression 27 has a steep slope, so that the yellow sand cannot escape, and is accumulated.

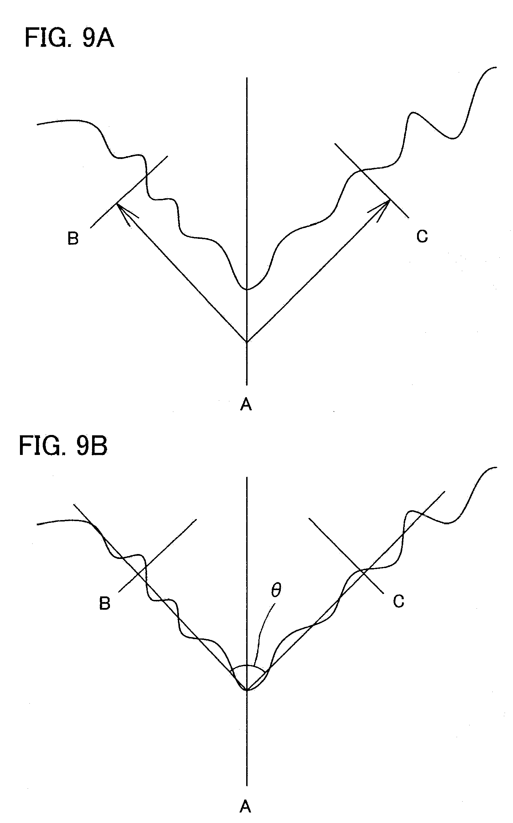

For a relatively large depression like the depression 27, particles of an abrasive material collide multiple times during the blast treatment, so that the hole is expanded, and therefore the inner surface of the depression 27 has a fine irregular shape as in Fig. 9. The straight lines B-A and C-A connect average-height portions of fine irregularities.

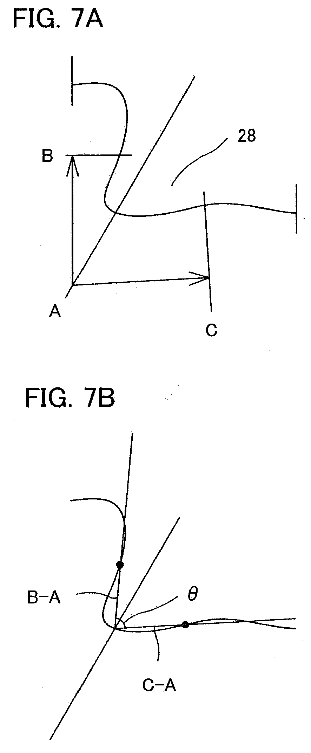

With regard to the depression 28, in the depression 28, the left and right reference points B and C exist substantially within the curved surface of the recessed portion and the angle θ is 90 degrees or less as shown in Fig. 7. The depression 28 is an overhang portion, and can be said to have a shape in which yellow sand is easily accumulated.

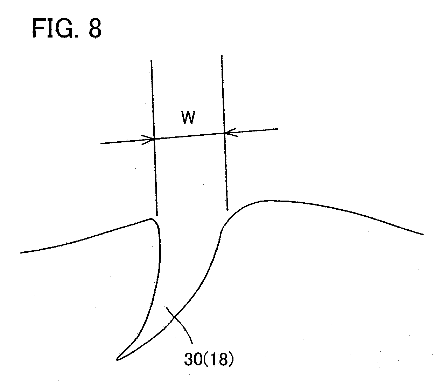

For the crack 18, attention is paid only to the opening width W as shown in Fig. 8. In a large crack 30 having an opening width W of 0.2 micrometer or more, yellow sand is caught. The crack 18 having an opening width W of less than 0.2 micrometer has no gap for yellow sand to enter.

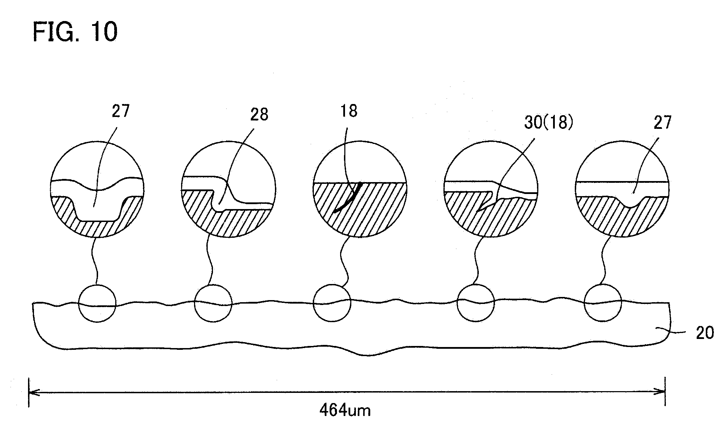

The glass substrate 2 of this embodiment will now be described. Fig. 10 is a sectional view of the glass substrate 2 of this embodiment. The sectional view in Fig. 10 illustrates a 464-micrometer range measured in parallel to the macroscopically smooth surface of the glass substrate 2. That is, provided that one compartment extends over 58 micrometers, a range of eight compartments is illustrated.

The glass substrate 2 of this embodiment includes the glass plate body 20 as a base as described above, and the glass plate body 20 has irregularities and cracks 18, but in the illustrated range, the number of depressions 27 and 28 classified as steep slope portions and cracks 30 classified as large cracks is small.

More specifically, there exist two depressions 27 which are classified as steep slope portions and in which the left and right reference points B and C exist substantially within the curved surface of the recessed portion and the angle θ is less than 135 degrees as in Fig. 6 described above.

There exists one depression 28 in which the left and right reference points B and C exist substantially within the curved surface of the recessed portion and the angle θ is 90 degrees or less as in Fig. 7.

Further, there exists one large crack 30 having an opening width W of 0.2 micrometer or more as in Fig. 8.

Therefore, the glass substrate 2 of this embodiment has a total of four steep slope portions and large cracks 30 per range of eight compartments. In other words, the average value of the number of steep slope portions and large cracks 30 per range of one compartment is 0.5. That is, it can be said that on average, 0.5 or more steep portions and large cracks 30 exist in the range of one compartment.

In addition, another crack 18 also exists, but the crack 18 has a narrow width, and thus does not allow yellow sand to enter.

That is, the glass plate body 20 of the solar cell module 1 of this embodiment has an irregular shape on a surface thereof, but the total of the number ND of depressions 27 and 28 classified as steep slope portions and the number NC of cracks 30 classified as large cracks is only 4. That is, the total of the number ND of depressions 27 and 28 classified as steep slope portions and the number NC of cracks 30 classified as large cracks is 0.5 per 58-micrometer compartment range. In the glass plate body 20 that forms the base of the glass substrate 2 of this embodiment, the number of portions in which the surface is largely depressed (recessed) is 0.5 or more and less than 5 per 58-micrometer compartment range, and thus very small.

Further, depressions 27 and 28 classified as minor steep slope portions are in a gently sloped state with the antireflection film 19 intruding thereinto as shown in Fig. 3. That is, the antireflection film 19 fills the bottoms of the depressions 27 and 28 to reduce the depths of the depressions 27 and 28. As a result, although depressions 27 and 28 are classified as steep slope portions when attention is paid to the glass plate body 20 alone, they turn into a shape that does not satisfy the requirement of the steep slope portion when an observation is made together with the antireflection film 19. That is, steep slope portions, large cracks and overhang portions existing on the surface of the glass plate body 20 are filled with the antireflection film, and thus the number of these portions is smaller on the surface of the antireflection film 19 than on the glass plate body 20.

Therefore, yellow sand is not easily accumulated on the glass substrate 2 of this embodiment.

A part of the antireflection film 19 penetrates into the crack 30 classified as a large crack to close the opening of the crack 30. Therefore, yellow sand is not caught in the crack 30. Therefore, yellow sand is not easily accumulated on the glass substrate 2 of this embodiment.

Further, in this embodiment, the antireflection film 19 also penetrates into the crack 18 having a narrow width (see Fig. 10 etc.).

In the glass substrate 2 that is employed in this embodiment, the surface is smoothed by the antireflection film 19, and the arithmetic mean deviation of the surface is 0.4 micrometer to 2.0 micrometers as described above, so that yellow sand is further less easily accumulated.

In the glass substrate 2 shown in Fig. 10, glass surface high level difference portions having an elevation difference of 0.7 micrometer or more in the height direction per 0.3 micrometer in a direction parallel to the macroscopically flat surface at the surface of the glass plate body 20 itself are distributed with the number thereof being 3 or less per 58-micrometer compartment range, and film surface high level-difference portions having an elevation difference of 0.7 micrometer or more per 0.3 micrometer at the surface of the antireflection film 19 are distributed with the number thereof being less than 1 per 58-micrometer compartment range.

Further, in the glass substrate 2 shown in Fig. 10, glass surface high level-difference portions having an elevation difference of 0.3 micrometer or more per 0.3 micrometer at the surface of the glass plate body 20 itself are distributed with the number thereof being 3 or less per 58-micrometer compartment range, and film surface high level-difference portions having an elevation difference of 0.3 micrometer or more per 0.3 micrometer at the surface of the antireflection film 19 are distributed with the number thereof being less than 1 per 58-micrometer compartment range.

Specifically, in the glass substrate 2 shown in Fig. 10, glass surface high level-difference portions having an elevation difference of 0.3 micrometer or more per 0.3 micrometer at the surface of the glass plate body 20 itself do not exist, and film surface high level-difference portions having an elevation difference of 0.3 micrometer or more per 0.3 micrometer at the surface of the antireflection film 19 do not exist.

As described above, in the glass plate body 20 itself that is employed in this embodiment, the contour line of the cross-sectional shape is finely waved by physical processing, but the number of steep slope portions in which an angle formed by a one-side pseudo-straight line obtained by pseudo-leveling of the contour line within 0.7 micrometer on one side and an other-side pseudo-straight line obtained by pscudo-leveling of the contour line within 0.7 micrometer on the other side is 135 degrees or less, and large cracks having an opening width of 0.2 micrometer or more is small, and the total number thereof is less than 5 in the 58-micrometer range of the macroscopically flat surface of the glass plate body 20. That is, the surface of the glass plate body 20 itself that is a base of the glass substrate 2 of this embodiment has fine irregularities, but does not have large irregularities.

That is, the number of steep slope portions and large cracks in which the surface is largely depressed (recessed) is very small.

The antireflection film 19 penetrates into the minor steep slope portions and large cracks, so that the steep slope portions and large cracks are filled with the antireflection film 19. That is, even at the portions in which steep slope portions and large cracks are formed, the contour line of the surface appears to draw a gentle curve when the glass substrate 2 is observed as a whole.

That is, when the antireflection film 19 is laminated on the glass substrate 2, the sharply rugged irregular surface of the glass substrate 2 turns into a gentle irregular surface. That is, the surface of the glass substrate 2 at which sharply rugged irregularity portions are found here and there is covered with the antireflection film 19, and the surface of the antireflection film 19 has only a small number of gentle irregularity portions. Accordingly, the surface of the solar cell module 1 has only a small number of gentle irregularity portions, and is hence a flat surface having a small number of irregularity portions that shows a large height difference.

That is, steep slope portions and large cracks existing on the surface of the glass plate body 20 itself are filled with the antireflection film 19, and thus the number of steep slope portions and large cracks existing on the surface of the antireflection film is smaller than the number of steep slope portions and large cracks existing on the surface of the glass plate body 20 itself. Therefore, the total number of steep slope portions and large cracks existing on the surface of the antireflection film 19 is less than 5 in the 58-micrometer range in a direction along the macroscopically flat surface of the glass plate body 20.

Accordingly, a stain is difficult to deposit on the surface of the solar cell module 1.

Specifically, when there is the sharply rugged irregularity shape 23, and a large number of large depressions, etc., exist, a substance that forms stains is caught or held in the depressed portions as in the case of yellow sand as described above. In this case, stains are not easily removed from the solar cell module.

On the other hand, in the solar cell module 1 of this embodiment, there is almost no such sharply rugged irregular shape 23 (large depressions and cracks having a wide opening), so that a stain is not easily fixed on the surface of the solar cell module, and the stain is easily removed.

In the solar cell module 1 of this embodiment, the surface of the glass substrate 2 is not completely smoothed, and is provided with a gentle irregularity portion, and reflected light is thus dispersed by the irregularity portion, so that the anti-glare property is maintained.

In the glass substrate 2 that is employed in this embodiment, cracks exist in the glass plate body 20 that is a base of the glass substrate, and the antireflection film 19 penetrates into the cracks as shown in Fig. 10. Hereinafter, adverse effects resulting from existence of cracks, and advantages resulting from penetration of the antireflection film 19 into cracks will be described in detail.

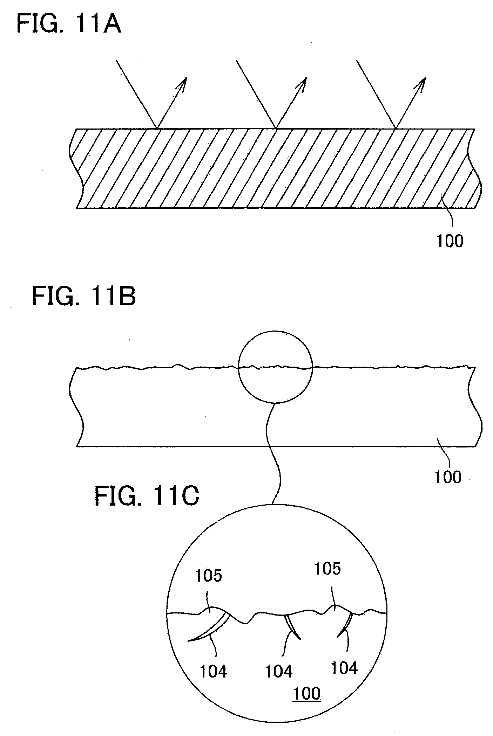

First, adverse effects resulting from existence of cracks will be described with reference to Figs. 11 to 13.

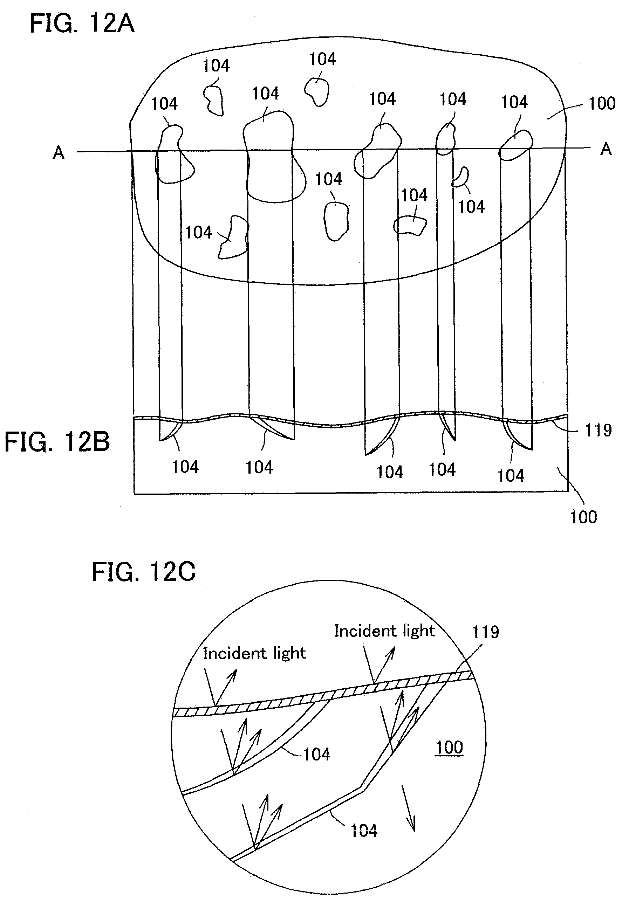

As a general rule, when cracks 104 are formed in a glass plate body 100 as in Fig. 11, light is reflected between the inner surface of the crack 104 and glass as shown in Fig. 12C. Particularly, the crack 104 with a fissure developing in a direction parallel to the glass substrate reflects light over a large area.

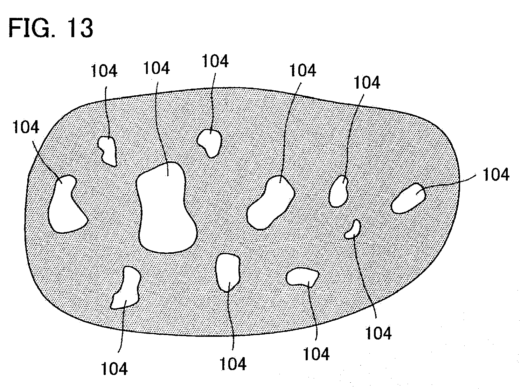

That is, when the cracks 104 are observed from the glass substrate side, the antireflection film 119 is situated on the surface side, and the glass plate body 100 is situated on the inside of the antireflection film 119 as shown in Fig. 12B. The cracks 104 exist on the surface of the glass plate body 100. The cracks 104 include those with a fissure developing in the depth direction of the glass plate body 100, and those with a fissure developing in a direction parallel to the glass plate body 100 as shown in Fig. 12B. When light impinges on the portion of the crack 104 with a fissure developing in a direction parallel to the glass plate body 100, light is reflected between the inner surface of the crack 104 and glass as shown in Fig. 12C. More specifically, light is reflected at a part of the boundary between the crack 104 and glass, which is situated on the outside (upper part in Fig. 12C) and a part of the boundary between the crack 104 and glass, which is situated on the inside (lower part in Fig. 12C). As a result, the portion of the crack 104 shines white as shown in Fig. 13.

Such a crack itself is very small, but is not preferable because a crack with a fissure developing in a direction parallel to the glass substrate has a structure in which a fragment sticks in a scaly form to the main body part of the glass substrate, and therefore the crack shines glitteringly. The reflected light does not contribute to emission of light as a matter of course.

Next, advantages resulting from penetration of the antireflection film 19 into cracks 18 will be described in detail.

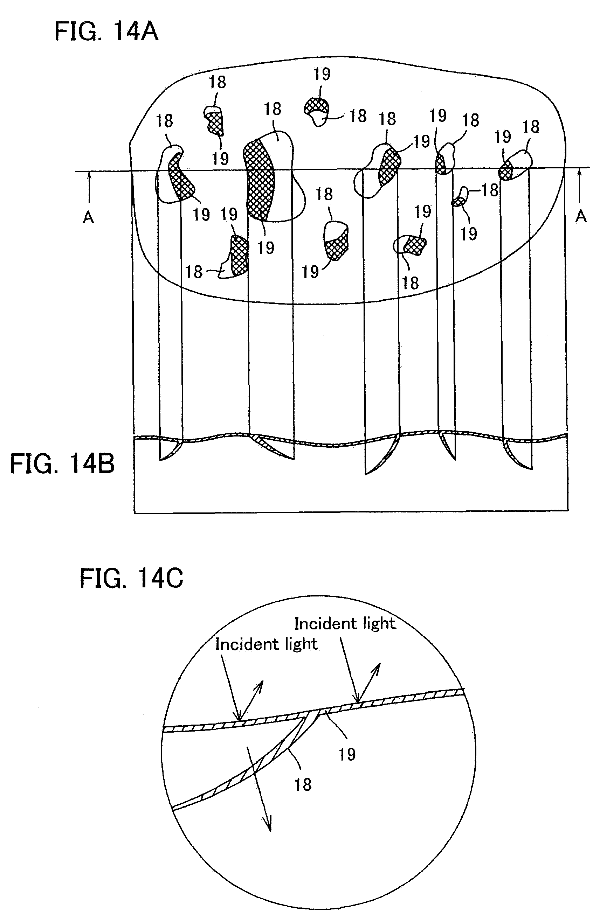

That is, in the glass plate body 20 that is a base of the glass substrate 2, cracks 18 exist as in, for example, Fig. 14. In Fig. 14, the size and number of cracks are intentionally exaggeratedly shown for making the explanation easier. Actually, the number of cracks is extremely small as in Fig. 10 described above.

The cracks 18 include lateral and fine cracks 18 (hereinafter, also referred to as lateral cracks 18) having components extending in a direction parallel to the macroscopically flat surface of the glass substrate 2.

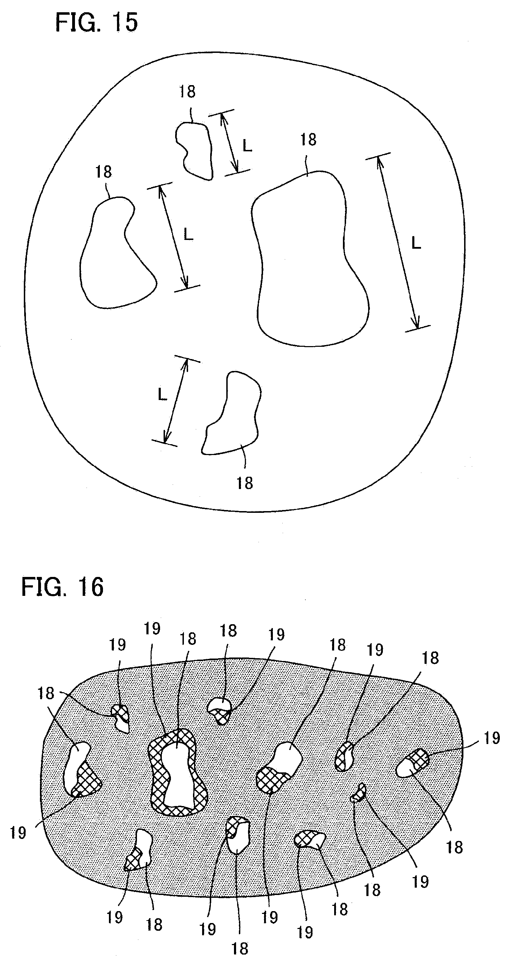

A crack 18 has a scaly and complicated shape when observed in plan view, but for the sake of convenience of explanation, the longest dimension in plan view is given a symbol L (see Fig. 15). In the descriptions below, this dimension is abbreviated as a maximum diameter L. The maximum diameter L can be said to be a maximum component in a direction parallel to the macroscopically flat surface in each crack 18.

In the solar cell module 1 of this embodiment, 10 or more lateral cracks 18 having a maximum diameter L of 4 micrometers or more exist per 1.69 × 10⁴ square micrometers. The lateral cracks 18 are generated incidentally, and therefore their distribution is not uniform. In this embodiment, there exist at least a plurality of regions where 15 or more lateral cracks 18 having a size of 6 micrometers or more exist per 1.69 × 10⁴ square micrometers.

In the solar cell module 1 of this embodiment, the antireflection film 19 is laminated on the surface of the glass substrate 2 as described above.

The antireflection film 19 is formed by air-drying a water-soluble titania silicon coating agent, and in this embodiment, a part of the antireflection film penetrates into the lateral crack 18.

The penetration of the antireflection film 19 into the lateral crack 18 is intentionally performed, but actually, the antireflection film 19 cannot be penetrated into the lateral crack 18 to the deepest part, and penetrates only to a part of the depth.

However, when a cross-section cutting through the glass substrate 2 in the thickness direction is observed, a portion in which a part of a substance that forms the antireflection film 19 penetrates into the lateral crack 18 is filled with the substance over the whole area in the thickness direction of the glass substrate 2. That is, in a space formed in the lateral crack 18, at least a part of a portion into which the substance penetrates is filled with the substance over the whole area in the thickness direction of the glass substrate 2.

A portion in which the substance that forms the antireflection film 19 penetrates into the lateral crack 18 over 3 micrometers or more exists at a plurality of locations on the glass substrate 2.

In the crack 18 into which the antireflection film 19 penetrates, gaps formed in the crack 18 are closed by the antireflection film 19, so that light is not easily reflected at the interface of the crack 18.

Therefore, as shown in Fig. 16, when the surface of the solar cell module 1 is observed, reflection of incident light at the crack 18 is reduced (the portion shining white is smaller) as compared to the surface in the conventional technology.

The refractive index of the antireflection film 19 of this embodiment can be set to a value between the refractive index of the glass plate body 20 and the refractive index of air. By doing so, regular reflection at the surface of the glass plate body 20 can be suppressed.

Specifically, when the purpose is only prevention of reflection at the surface of the glass plate body 20, the refractive index of the antireflection film 19 is ideally 1.30 to 1.4, a value that is just the middle between the refractive index of air (1.0) and the refractive index of the glass plate body 20 (about 1.5 to 1.6). However, in this embodiment, not only is reflection at the outermost surface prevented, but also the antireflection film 19 is penetrated into the crack 18 to suppress reflection at the interface of the glass plate body 20/antireflection film 19/glass plate body 20. In this case, when the refractive index of the antireflection film 19 is made equal to the refractive index of the glass plate body 20, reflection at the interface of the glass plate body 20/antireflection film 19/glass plate body 20 in the crack 18 ideally becomes zero. Therefore, the refractive index of the antireflection film 19 is preferably 1.60 or less for suppressing reflection at the surface of the glass plate body 20, and is preferably 1.35 or more for suppressing reflection at the interface of the glass plate body 20/antireflection film 19/glass plate body 20 in the crack 18.

The solar cell module 1 described above is one that is referred to as a so called thin-film solar cell. However, the present invention is not limited to this example as a matter of course. The present invention is employed not only for solar cell modules referred to as a so called thin-film type, but may also be employed for solar cell modules including a solar cell referred to as a crystal type.

That is, the present invention may be applied to a solar cell module obtained by doping a semiconductor wafer of polycrystalline silicon, etc., with phosphorus, boron, or the like to prepare a solar cell, and providing a glass plate for the purpose of protecting the surface of the solar cell. The present invention may be applied to a protecting glass plate that is used in this type of solar cell module.

That is, the present invention can be suitably employed in any solar cell with glass (cover glass) disposed on the light-incident surface.

### EXAMPLES

Next, specific examples of the present invention will be described.

### (Example 1)

A solar cell module 1 in this example is a thin-film-type and integrated-type solar cell module.

That is, the solar cell module 1 of this example is one obtained by forming a transparent electrode layer 10, a semiconductor thin-film photoelectric conversion layer 11, a back transparent electrode layer 12, and a back metal electrode layer 13 on a glass substrate 2 by film forming means, and can be said to be a thin-film-type solar cell module.

The solar cell module 1 of this example is one produced through the following steps.

The step of producing the solar cell module 1 is divided broadly into a photoelectric conversion unit production step and a surface treatment step. Among them, the photoelectric conversion unit production step is identical to that in a known solar cell module production step, and is thus described briefly.

In the photoelectric conversion unit production step, as shown in Fig. 2, first the transparent electrode layer 10 is formed on the back surface side (surface situated at a position opposite to the light-incident surface) of the glass substrate 2 (see Fig. 2A), and laser scribing is performed to divide the transparent electrode layer 10 (see Fig. 2B).

Subsequently, the semiconductor thin-film photoelectric conversion layer 11 is formed on the transparent electrode layer 10 (see Fig. 2C), and laser scribing is performed to divide the formed semiconductor thin-film photoelectric conversion layer 11 (see Fig. 2D). Further, as a back electrode, the back transparent electrode layer 12 and the back metal electrode layer 13 are formed (see Fig. 2E and 2F). Laser scribing is performed to appropriately divide the formed back transparent electrode layer 12 and back metal electrode layer 13 (see Fig. 2G).

Through these steps, a plurality of solar cells 14 are formed, and they are mutually electrically connected. That is, a photoelectric conversion unit 3 is a laminated body formed by stacking a plurality of layers, and is an optical semiconductor element formed by integrating a plurality of solar cells 14.

The formed photoelectric conversion unit 3 is protected with a resin and a back sheet 4 (see Fig. 1, etc.,) to complete the photoelectric conversion unit production step.

Subsequently, the surface treatment step of subjecting the light-incident surface of the glass substrate 2 to a surface treatment is carried out.

The surface treatment step is further divided into a roughening step, a water-washing step, and an antireflection film forming step.

In the roughening step, a surface of the glass substrate 2 is subjected to blast processing over a plurality of times for forming an irregular surface on the light-incident surface of the glass substrate 2. In this example, blast processing is performed twice, and the roughening step is a step of carrying out a first roughening step of performing first blast processing, and a second roughening step of performing blast processing subsequent to the first blast processing step.

The blast processing performed in the first roughening step is one in which sand blasting is performed using an abrasive material. As the abrasive material, white alumina can be suitably employed, and an abrasive material having a size in a range of #40 to #600 in terms of a nominal count can be suitably employed.

When the roughening step is carried out, an irregular surface is formed on the light-incident surface of the glass substrate 2.

The blast processing performed in the second roughening step is also one in which sand blasting is performed using an abrasive material. As the abrasive material, white alumina can be suitably employed, and an abrasive material having a size in a range of #400 to #3000 in terms of a nominal count can be suitably employed.

Here in the second roughening step of this embodiment, an abrasive material having a particle size smaller as compared to that in the first roughening step is used. By carrying out the second roughening step, defects on the surface which occur in the first roughening step are removed.

By performing the surface treatment including the above-described steps, an irregular surface having an arithmetic mean deviation of 0.4 micrometer to 10 micrometers could be formed, and almost all defects on the glass surface, which had existed at the time of completion of the first roughening step, could be eliminated. More specifically, by using an abrasive material capable of being suitably employed, an irregular surface having an arithmetic mean deviation of 0.4 micrometer to 2 micrometers, more specifically an irregular surface having an arithmetic mean deviation of 0.42 micrometer could be formed.

Further, subsequent to the roughening step, the water-washing step is carried out. This step is a step of washing the blast-processed glass substrate with water. Specifically, the water-washing step is a step of washing a portion as the light-incident surface of the glass substrate 2 using city water.

Thereafter, the antireflection film forming step is carried out.

In the antireflection film forming step, a water-soluble titania silicon coating agent containing fine particles composed of a titanium oxide and a silicon oxide are applied by a spray, and air-dried to form an antireflection film 19 (see Fig. 3, etc.). The antireflection film forming step is a step of forming the antireflection film 19 (see Fig. 3, etc.) without performing a hydrophilization treatment using a hydrophilization treatment agent.

An antireflection film was formed on a flat glass substrate in a step identical to the step of forming the antireflection film 19, and a refractive index at a wavelength of 600 nm was measured using spectroscopic ellipsometry. As a result, the refractive index was 1.43.

The solar cell module 1 is completed upon completion of the antireflection film forming step.

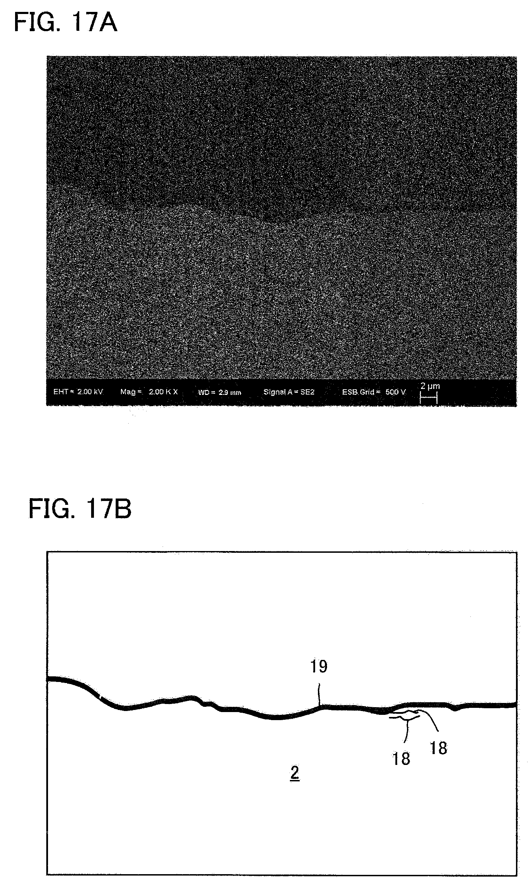

Figs. 17 to 22 are cross-section-enlarged photographs (scanning electron microscope images: SEM images) of the glass substrate 2 after completion of the antireflection film forming step, and trace diagrams of these cross-section-enlarged photographs. These parts have a length of 58 micrometers in the horizontal direction. That is, the part shown in the photograph corresponds to a 58-micrometer range measured in parallel to the macroscopically smooth surface of the glass substrate 2. Cross-section-enlarged photographs (SEM images) as shown in Figs. 17, 19, and 21 can be obtained with a magnification of several hundred times to several thousand times.

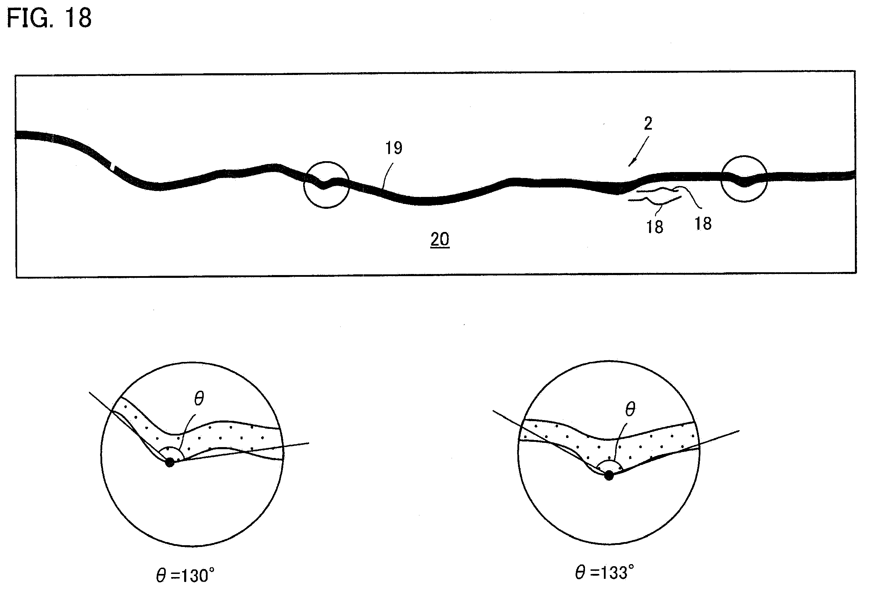

In the range shown in Figs. 17 and 18, two depressions 50 with the angle θ being 135 degrees or less existed on the surface of the glass plate body 20. In the range shown in Figs. 17 and 18, the large crack 30 having an opening width W of 0.2 micrometer or more was not observed.

That is, the total number of steep slope portions with the angle θ being 135 degrees or less and large cracks having an opening width of 0.2 micrometer or more was confirmed to be 2, and thus less than 5.

Also, on the surface of the antireflection film 19, the depression 50 with the angle 0 being 135 degrees or less and the large crack 30 having an opening width W of 0.2 micrometer or more were not observed.

That is, the total number of steep slope portions with the angle θ being 135 degrees or less and large cracks having an opening width of 0.2 micrometer or more was confirmed to be 0, and thus less than 5.

On the surface of the glass plate body 20, glass surface high level-difference portions having an elevation difference of 0.3 micrometer or more per 0.3 micrometer at the surface of the glass plate body 20 itself and film surface high level-difference portions having an elevation difference of 0.3 micrometer or more per 0.3 micrometer at the surface of the antireflection film 19 did not exist.

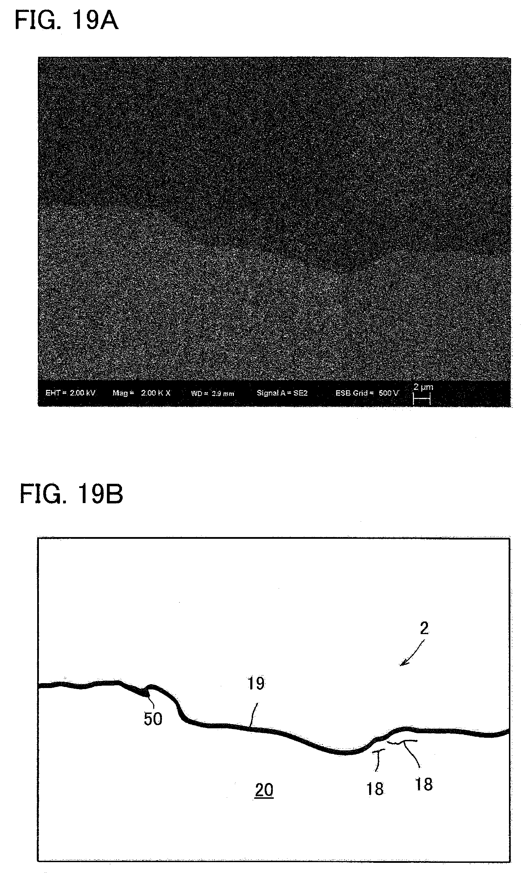

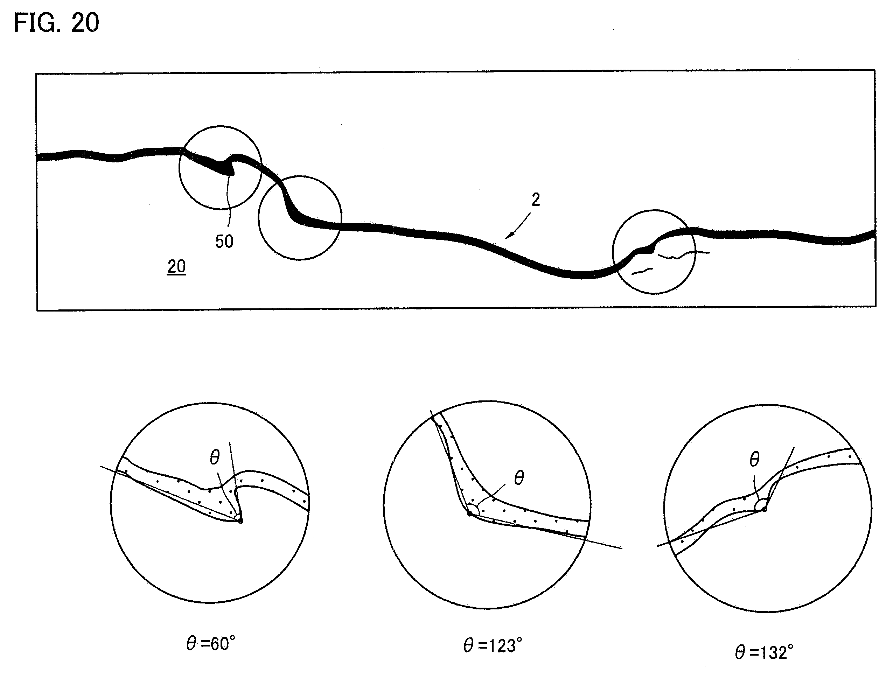

In the range shown in Figs. 19 and 20, three depressions 50 with the angle θ being 135 degrees or less were observed, and the large crack 30 having an opening width W of 0.2 micrometer or more was not observed.

That is, the total number of steep slope portions with the angle θ being 135 degrees or less and large cracks having an opening width of 0.2 micrometer or more was confirmed to be 3, and thus less than 5.

The antireflection film 19 penetrates into the observed depression 50. In other words, the depression 50 is filled with the antireflection film 19. That is, when the antireflection film 19 is laminated, the boundary line between the antireflection film 19 and the outside draws a gentle curve at a portion situated at the outside of the depression 50 (portion situated on the upper side in Fig. 20).

On the surface of the antireflection film 19, the depression 50 with the angle θ being 135 degrees or less and the large crack 30 having an opening width W of 0.2 micrometer or more were not observed.

That is, the total number of steep slope portions with the angle θ being 135 degrees or less and large cracks having an opening width of 0.2 micrometer or more was confirmed to be 0, and thus less than 5.

On the surface of the glass plate body 20, three glass surface high level-difference portions having an elevation difference of 0.7 micrometer or more per 0.3 micrometer at the surface of the glass plate body 20 itself were observed.

Film surface high level-difference portions having an elevation difference of 0.7 micrometer or more per 0.3 micrometer at the surface of the antireflection film 19 do not exist.

On the surface of the glass plate body 20, six glass surface high level-difference portions having an elevation difference of 0.3 micrometer or more per 0.3 micrometer at the surface of the glass plate body 20 itself were observed.

There existed one film surface high level-difference portion having an elevation difference of 0.3 micrometer or more per 0.3 micrometer at the surface of the antireflection film 19.

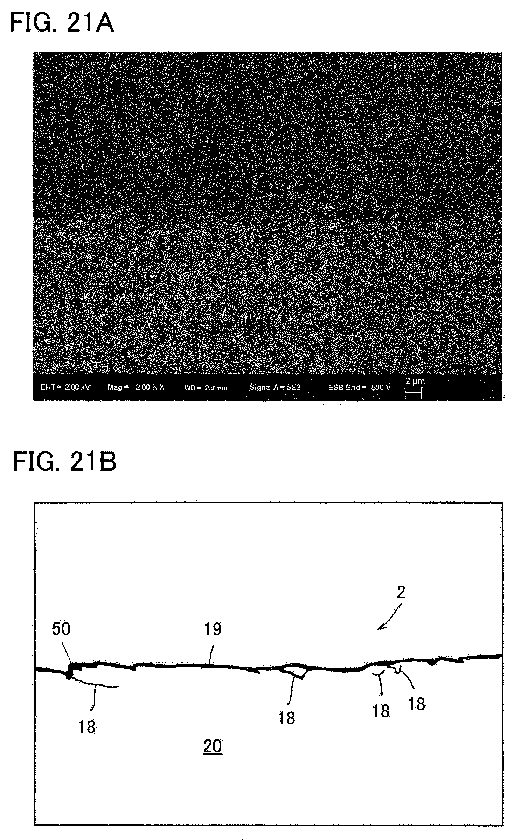

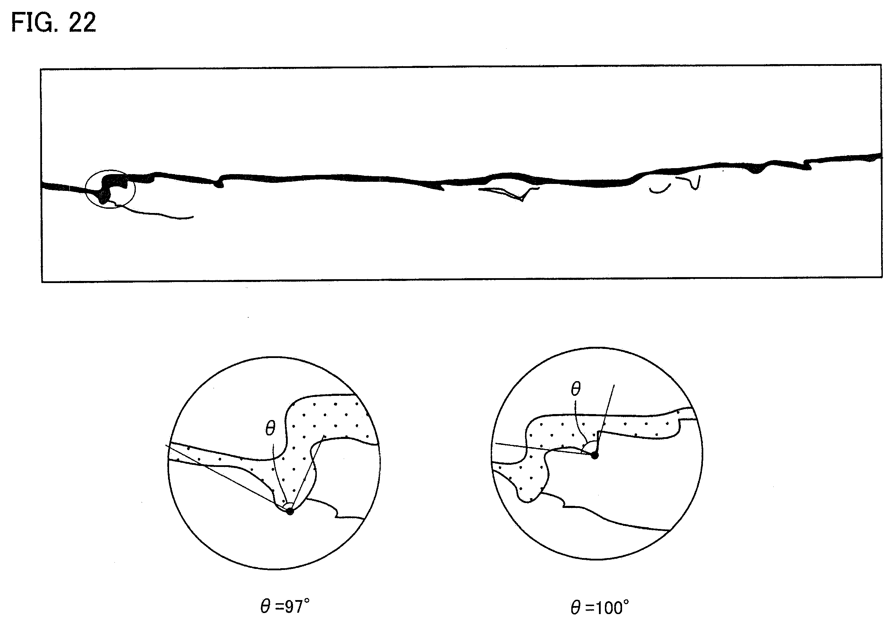

In the range shown in Figs. 21 and 22, only two depressions 50 with the angle θ being 135 degrees or less were observed, and the large crack 30 having an opening width W of 0.2 micrometer or more was not observed on the surface of the glass plate body 20.

That is, the total number of steep slope portions with the angle θ being 135 degrees or less and large cracks having an opening width of 0.2 micrometer or more was confirmed to be 2, and thus less than 5.

The antireflection film 19 penetrates into the observed depression 50. In other words, the depression 50 is filled with the antireflection film 19. That is, when the antireflection film 19 is laminated, the boundary line between the antireflection film 19 and the outside draws a gentle curve at a portion situated at the outside of the depression 50 (portion situated on the upper side in Fig. 20).

On the surface of the antireflection film 19, only one depression 50 with the angle θ being 135 degrees or less was observed, and the large crack 30 having an opening width W of 0.2 micrometer or more were not observed (lines, etc., are omitted in the Figure).

That is, the total number of steep slope portions with the angle θ being 135 degrees or less and large cracks having an opening width of 0.2 micrometer or more was confirmed to be 1, and thus less than 5.

On the surface of the glass plate body 20, one glass surface high level-difference portion having an elevation difference of 0.7 micrometer or more per 0.3 micrometer at the surface of the glass plate body 20 itself was observed.

There exists one film surface high level-difference portion having an elevation difference of 0.7 micrometer or more per 0.3 micrometer at the surface of the antireflection film 19.

On the surface of the glass plate body 20, five glass surface high level-difference portions having an elevation difference of 0.3 micrometer or more per 0.3 micrometer at the surface of the glass plate body 20 itself were observed.

There existed three film surface high level-difference portions having an elevation difference of 0.3 micrometer or more per 0.3 micrometer at the surface of the antireflection film 19.

In this example, a surface (light-incident surface) of the solar cell module is smoothed in this way to provide a structure in which yellow sand is not easily accumulated, so that the antifouling property is improved. For verifying the antifouling property of the solar cell module of this example, the following verification was performed.

The solar cell module of this example and a solar cell module produced by a conventional technology were each scattered with sand in the state of lying down. Thereafter, one side of each of the solar cell modules was lifted, and the solar cell module was erected in the state of being inclined at an angle of 45 degrees with respect to the ground surface.

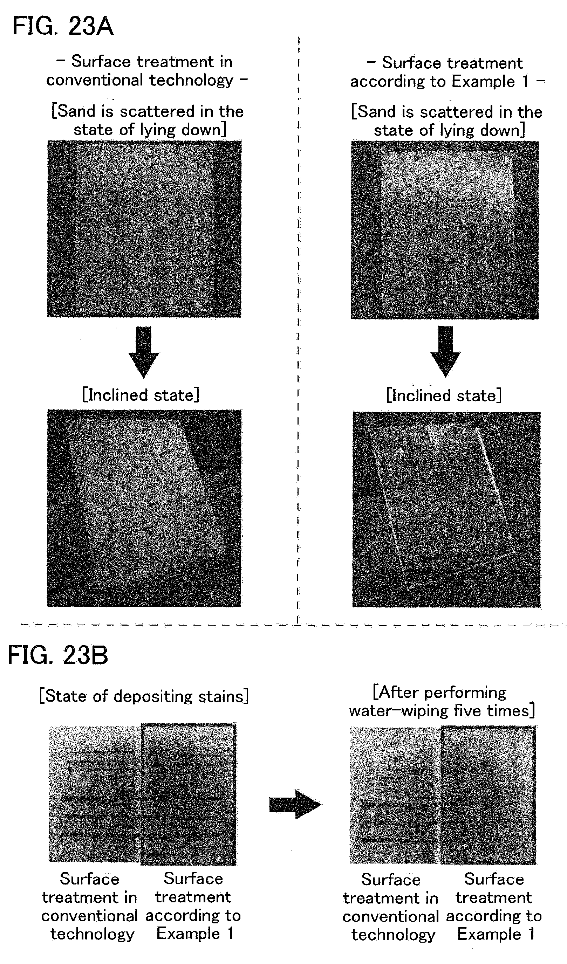

As a result, in the solar cell module of this example, sand was removed from areas constituting 90 percent of the whole region scattered with sand when the solar cell module was inclined at an angle of 45 degrees as shown in Fig. 23A. On the other hand, in the solar cell module produced by the conventional technology, almost no sand was removed. That is, the solar cell module of this example was shown to have a structure in which yellow sand was not easily accumulated, and stains were not easily deposited.

Further, using a pencil and an oil-based marker, stains were deposited on the solar cell module of this example and the solar cell module produced by the conventional technology. The solar cell modules were each wiped with a damp cloth five times, and a comparison was made on how the stains were removed.

As a result, as shown in Fig. 23B, it was confirmed that in the solar cell module of this example, stains were more easily removed as compared to the solar cell module produced by the conventional technology. That is, the solar cell module of this example was confirmed to have a high antifouling property.

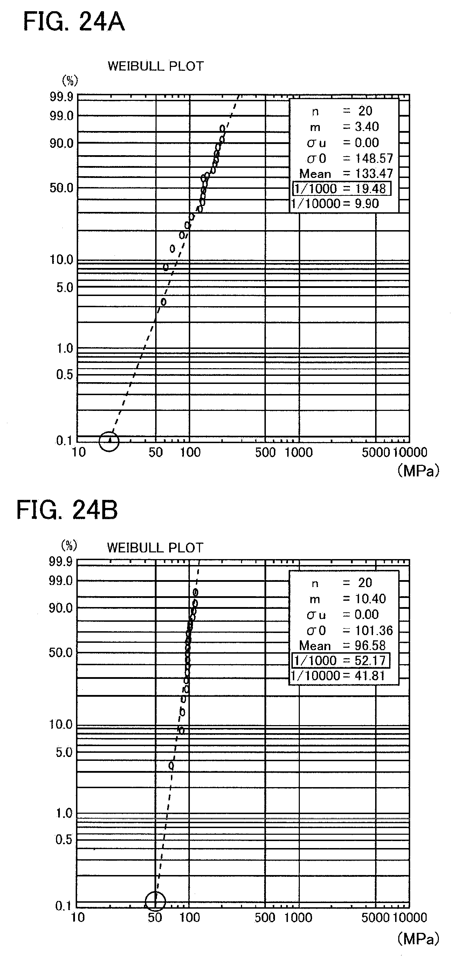

Subsequently, a ring bending test was conducted for each of a glass plate subjected to the first roughening step, the second roughening step, and the antireflection film forming step; and a usual glass plate that had not been subjected to these steps. Then, a comparison was made on the strength. Results of measurements in the ring bending test, which are represented in the form of a Weibull plot, are shown in Fig. 24.

As a result, the pressure at which the usual glass plate was broken with a probability of 0.1 percent was about 20 MPa (see Fig. 24A), whereas the pressure at which the glass plate was subjected to the following steps: the first roughening step, the second roughening step, and the antireflection film forming step was broken with a probability of 0.1 percent was about 50 MPa (see Fig. 24B).

That is, the solar cell module of this example was shown to exhibit a high strength even when having a structure capable of improving the antifouling property. The reason why the glass plate of this example has a strength higher than that of the usual glass plate may be that the distortion of the glass plate itself is relaxed through the first roughening step and the second roughening step.

As described above, in the solar cell module of this example, the glass plate body is physically processed to be made microscopically irregular, and further, the antireflection film is penetrated into fine cracks to improve the anti-glare property.

For verifying the anti-glare property of the solar cell module of this example, the following verification was performed.

For the solar cell module 1 of this example, the values of glass surface-cracked area ratio, short-circuit current value retention rate, total reflectivity on the incident surface side, arithmetic mean deviation of the surface, glossiness, and reflected glare were measured.

More specifically, the values were measured before performing the surface treatment, after carrying out the first roughening step, after carrying out the second roughening step, and after carrying out the antireflection film forming step.

The glass surface-cracked area ratio was measured by the following method.

Cracked portions of a surface (light-incident surface) of the glass substrate 2 was identified from an enlarged image of a glass surface of 130 micrometers × 130 micrometers. The cracked portion is a region where reflection is stronger as compared to neighboring portions in optical observation with reflected light. The measurement was performed using a laser microscope (model: LEXT OLS4000 manufactured by Olympus Corporation).

The arithmetic mean deviation of the surface was measured by the following method.

The measurement was performed with a setting of cutoff λ_{c} 80 micrometers using a laser microscope (model: LEXT OLS4000 manufactured by Olympus Corporation).

The glossiness was measured by the following method.

The glossiness was measured at an incidence angle of 60 degrees using a glossimeter (Gloss Checker IG-320 manufactured by HORIBA, Ltd.) by a method conforming to the specular glossiness measurement method described in JIS Z8741-1997.

The reflected glare was measured by the following method.

A halogen lamp lighted in a black curtain was visually observed at a normal line angle of 60 degrees with respect to a module glass surface, and whether or not it was able to observe a filament of the halogen lamp was determined.

As a result of these measurements, the results shown in Table 1 below were obtained.

**Table 1**

| | Unit | Before surface treatment | After first blast processing step | After second blast processing step | After lamination of antireflection film |
|---|---|---|---|---|---|
| Glass surface-cracked area ratio | % | 0.0 | 27.2 | 4.4 | 2.2 |
| Short-circuit current value retention rate | % | 100.0 | 97.7 | 99.5 | 100.2 |
| Total reflectivity on incident surface side | % | 7.5 | 9.4 | 7.7 | 6.8 |
| Arithmatic mean roughness of surface | µm | 0.0 | 1.0 | 0.50 | 0.42 |
| Glossiness | - | 135.0 | 1.9 | 4.6 | 5.2 |
| Reflected Glare | - | Present | Absent | Absent | Absent |

The solar cell module of this example formed by carrying out the above-described steps is confirmed to have an improved power output (short-circuit current value retention rate) and an improved anti-glare property (reduced total reflectivity) as compared to a conventional solar cell module which is not subjected to the steps (solar cell module at the completion of the photoelectric conversion unit production step).

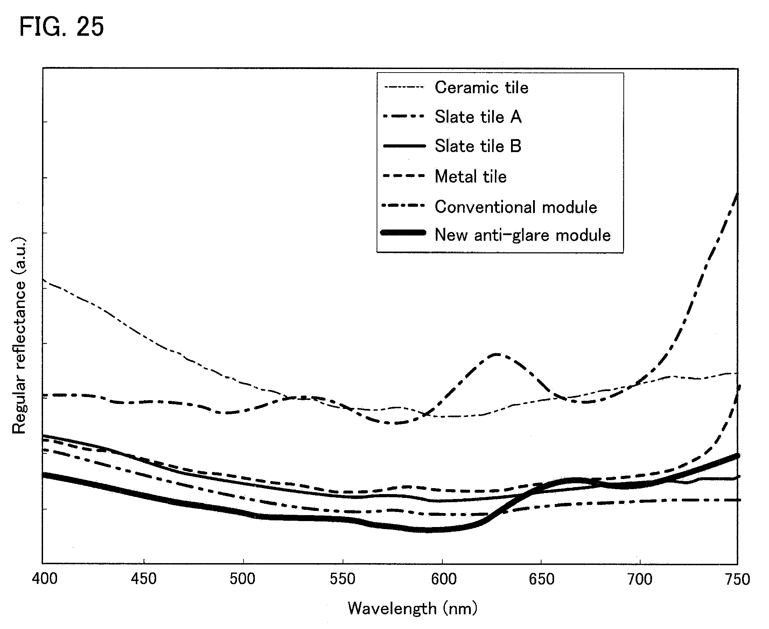

Further, the solar cell module of this example was compared with the solar cell module produced by the conventional technology and various kinds of roof materials for the regular reflectance at an incidence angle of 8 degrees. The results thereof are shown in Fig. 25.

The roof materials used for comparison are four different roof materials including a ceramic tile, two different slate tiles (slate tile A and slate tile B), and a metal tile. In the graph of Fig. 25, the horizontal axis shows the wavelength of light applied to the object, and the vertical axis shows the regular reflectance.

As a result, the solar cell module of this example is confirmed to have a reduced regular reflectance as compared to the solar cell module produced by the conventional technology.

Further, the solar cell module of this example was relatively compared with the solar cell module produced by the conventional technology and various kinds of roof materials for the reflectance at an incidence angle of 60 degrees. As a result, the results shown in Table 2 below were obtained. Each value shown in Table 2 is a ratio of the reflectance where the reflectance of the ceramic tile is 1.

**Table 2**

| Solar cell module (second example) | Solar cell module (conventional technology) | Metal tile | Ceramic tile | Slate tile A | Slate tile B tile B |
|---|---|---|---|---|---|
| 0.34 | 16.94 | 0.23 | 1.00 | 0.25 | 0.68 |

As a result, the solar cell module of this example was confirmed to have a reduced reflectance at an incidence angle of 60 degrees as compared to the solar cell module produced by the conventional technology.

The antireflection film laminated on the solar cell module of this example was compared with the antireflection film of the solar cell module produced by the conventional technology for the viscosity before curing. A comparison was made on the viscosity of the antireflection film (substance for forming the antireflection film) immediately after it was applied on the glass substrate. As a result, the results shown in Table 3 below were obtained. In Table 3, the viscosity of pure water is also described for reference.

**Table 3**

| Liquid | Viscosity (mPa▪s) |
|---|---|
| Pure water | 0.92 |
| Antireflection film (Present application) | 0.98 |
| Antireflection film (Conventional Technology) | 2.83 |

It is confirmed that in the solar cell module of this example, the viscosity before curing is extremely lower as compared to the conventional technology, and is very close to that of pure water. In this example, the viscosity of the antireflection film before curing is reduced, so that the antireflection film sufficiently penetrates into depressions and cracks formed on the surface of the glass substrate.

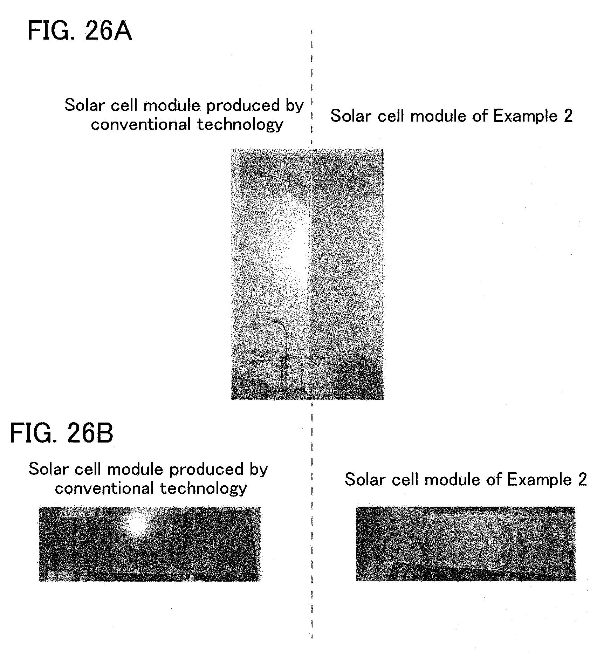

The solar cell module of this example and the solar cell module produced by the conventional technology were each photographed in the state of being irradiated with the same light, and a glare felt by a person was examined. As a result, as shown in Fig. 26, the solar cell module produced by the conventional technology is confirmed to shine more intensely than the solar cell module of this example. That is, it is confirmed that the solar cell module of this example barely caused a person to feel a glare in a state of being irradiated with light, and thus has a high anti-glare property.

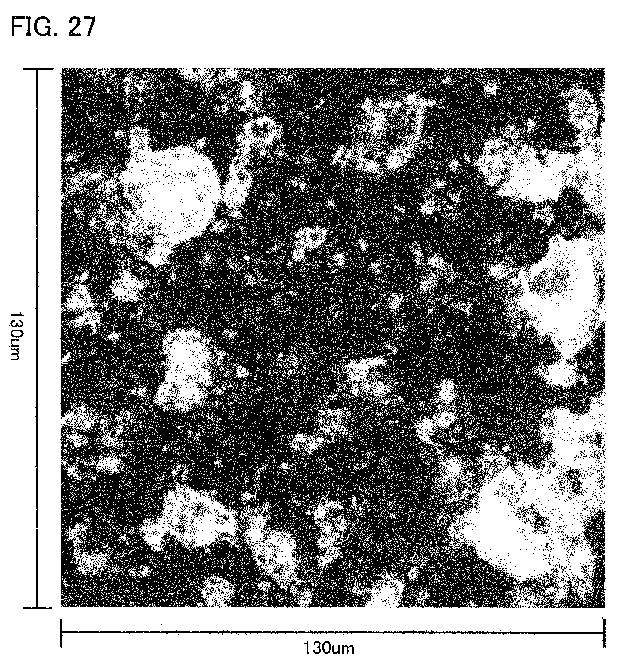

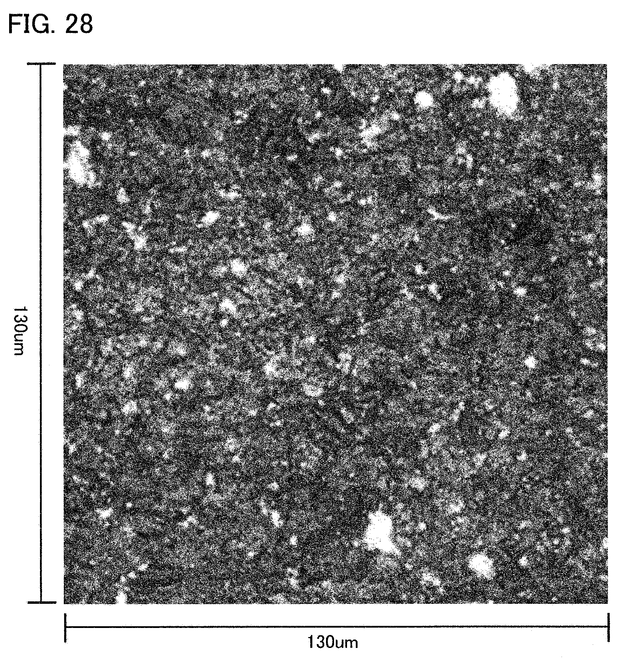

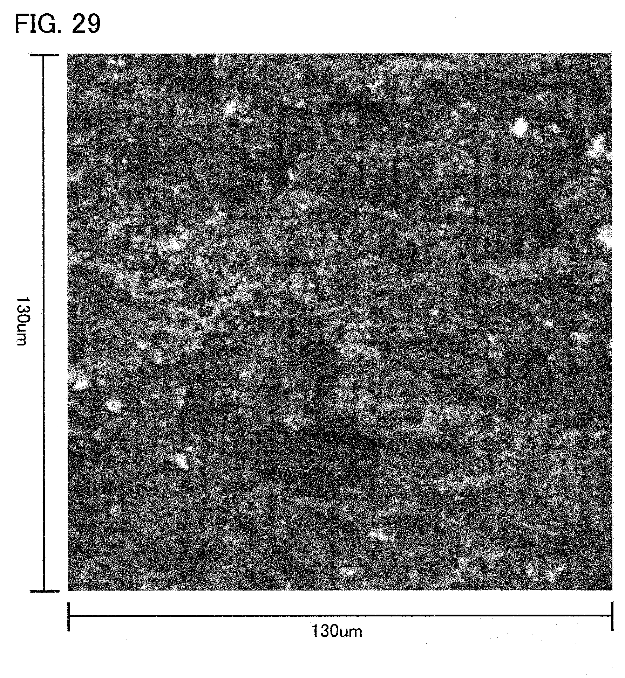

Further, a microscope photograph (optical image) showing the surface of the glass substrate 2 was taken after the first roughening step, after the second roughening step, and after the antireflection film forming step. Figs. 27, 28, and 29 are microscope photographs (optical images) showing the surface of the glass substrate 2 after the first roughening step, after the second roughening step, and after the antireflection film forming step, respectively.

It is shown that the reflection of incident light is reduced (the portions shining white was reduced) by carrying out these steps.

### (Comparative Example 1)

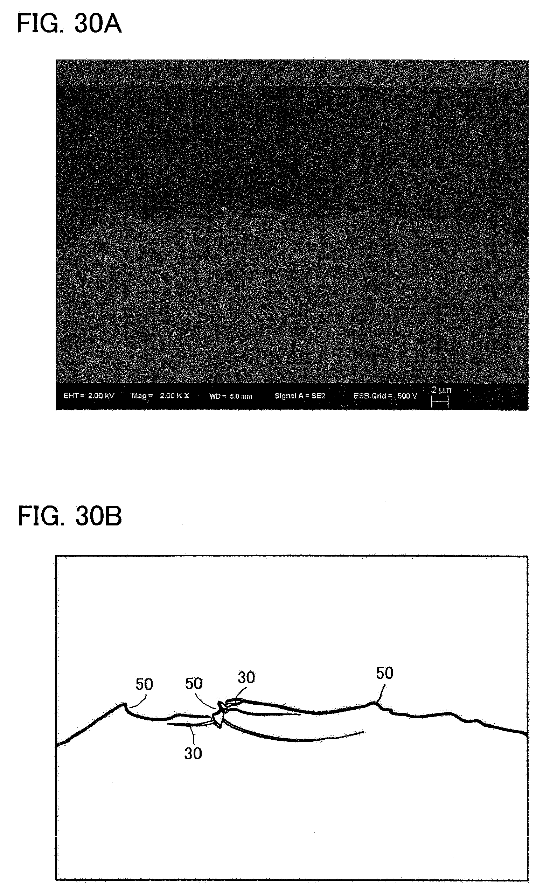

A solar cell module was produced by the method described in Patent Document 3, and a cross-section-enlarged photograph (scanning electron microscope image: SEM image) was taken. Cross-section-enlarged photographs and trace diagrams of the cross-section-enlarged photograph are shown in Figs. 30 to 38. The part shown in the photograph has a length of 58 micrometers in the horizontal direction. That is, the part shown in the photograph corresponds to a 58-micrometer range measured in parallel to the macroscopically smooth surface of the glass substrate 2. Cross-section-enlarged photographs (SEM images) as shown in Figs. 30, 33, and 36 can be obtained with a magnification of several hundred times to several thousand times.

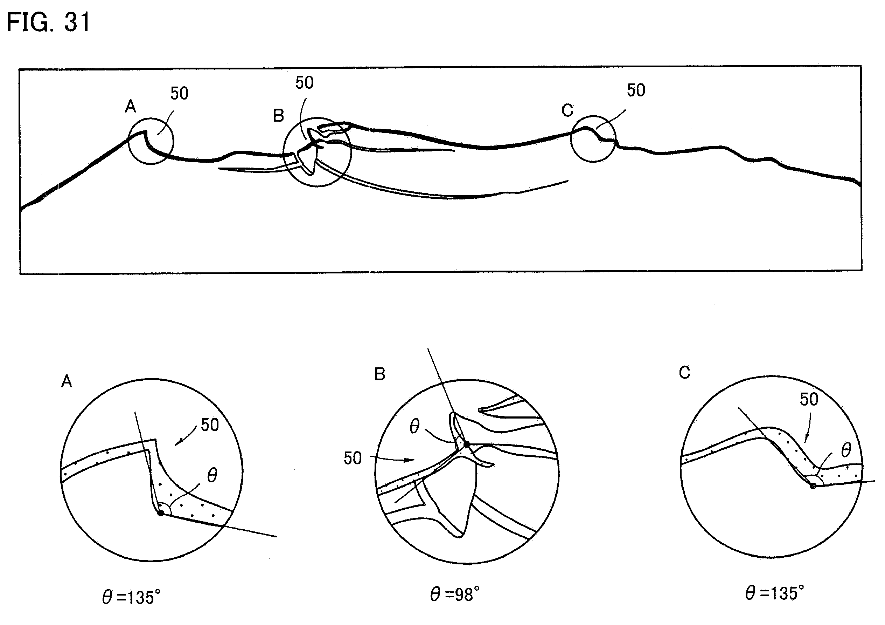

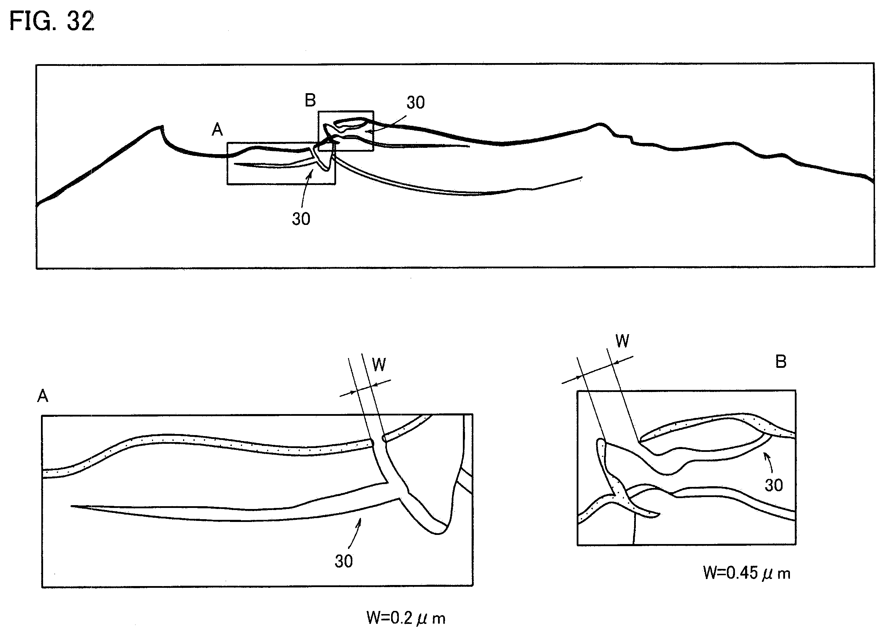

In the range shown in Figs. 30 to 32, three depressions 50 with the angle θ being 135 degrees or less were observed (see Fig. 31). Further, two large cracks 30 having an opening width W of 0.2 micrometer or more were observed (see Fig. 32).

That is, the total number of steep slope portions with the angle θ being 135 degrees or less and large cracks having an opening width of 0.2 micrometer or more was confirmed to be 5.

Similarly on the surface of the antireflection film 19, three depressions 50 with the angle θ being 135 degrees or less were observed (see Fig. 31). Further, two large cracks 30 having an opening width W of 0.2 micrometer or more were observed (see Fig. 32).

On the surface of the glass plate body 20, two glass surface high level-difference portions having an elevation difference of 0.7 micrometer or more per 0.3 micrometer at the surface of the glass plate body 20 itself were observed.

There exist two film surface high level-difference portions having an elevation difference of 0.7 micrometer or more per 0.3 micrometer at the surface of the antireflection film 19.

On the surface of the glass plate body 20, five glass surface high level-difference portions having an elevation difference of 0.3 micrometer or more per 0.3 micrometer at the surface of the glass plate body 20 itself were observed.

There existed five film surface high level-difference portions having an elevation difference of 0.3 micrometer or more per 0.3 micrometer at the surface of the antireflection film 19.

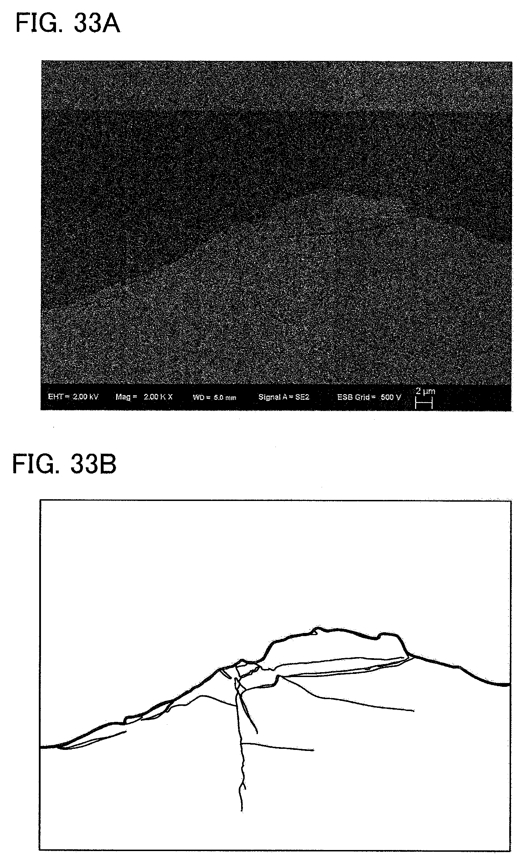

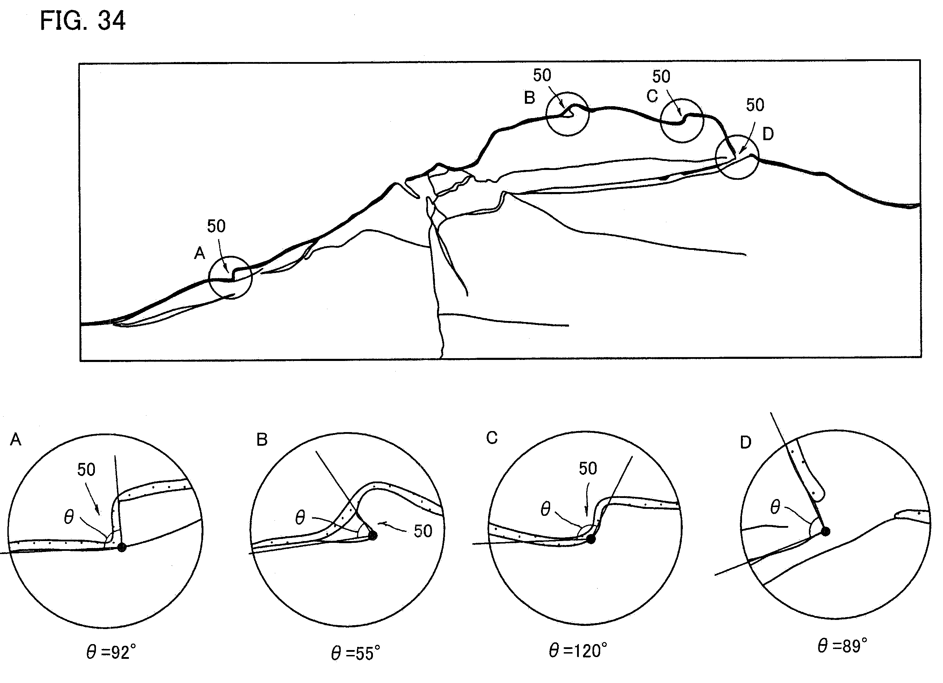

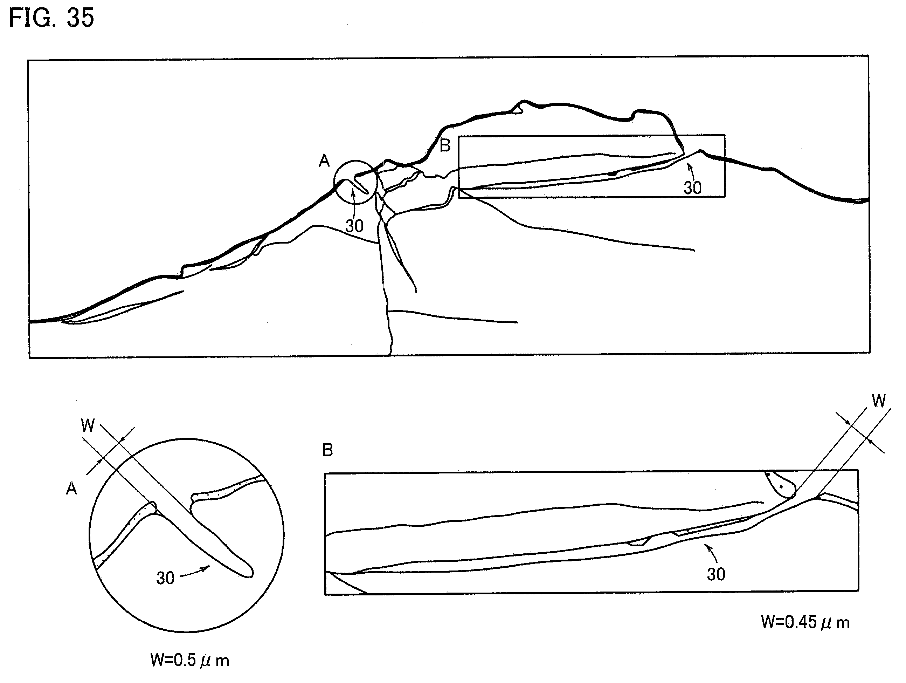

In the range shown in Figs. 33 to 35, four depressions 50 with the angle θ being 135 degrees or less were observed (see Fig. 34). Further, two large cracks 30 having an opening width W of 0.2 micrometer or more were observed (see Fig. 35).

That is, the total number of steep slope portions with the angle θ being 135 degrees or less and large cracks having an opening width of 0.2 micrometer or more was confirmed to be 6.

Similarly, also on the surface of the antireflection film 19, three depressions 50 with the angle θ being 135 degrees or less were observed, and two large cracks 30 having an opening width W of 0.2 micrometer or more were observed. That is, the total number of steep slope portions with the angle θ being 135 degrees or less and large cracks having an opening width of 0.2 micrometer or more was confirmed to be 5.

On the surface of the glass plate body 20, three glass surface high level-difference portions having an elevation difference of 0.7 micrometer or more per 0.3 micrometer at the surface of the glass plate body 20 itself were observed.

There exist two film surface high level-difference portion having an elevation difference of 0.7 micrometer or more per 0.3 micrometer at the surface of the antireflection film 19.

On the surface of the glass plate body 20, six glass surface high level-difference portions having an elevation difference of 0.3 micrometer or more per 0.3 micrometer at the surface of the glass plate body 20 itself were observed.

There existed five film surface high level-difference portions having an elevation difference of 0.3 micrometer or more per 0.3 micrometer at the surface of the antireflection film 19.

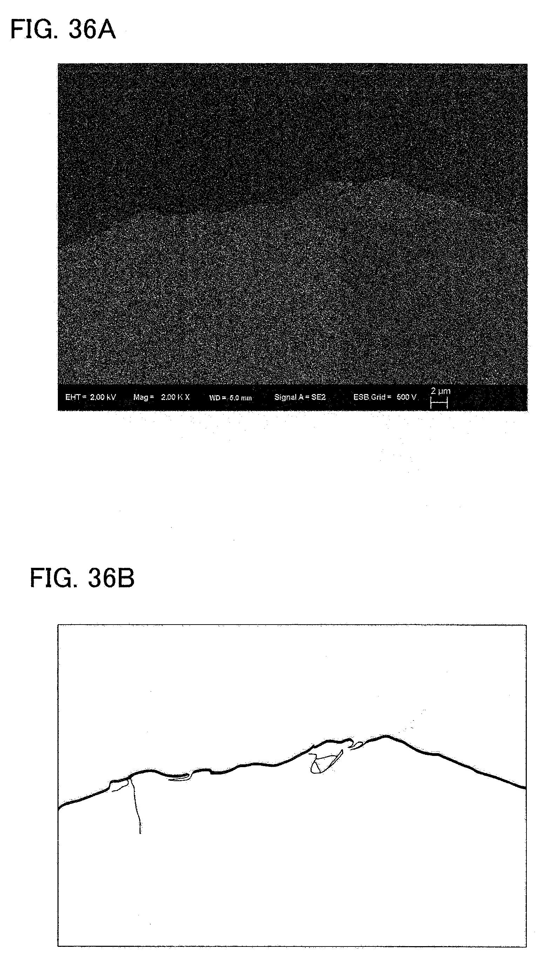

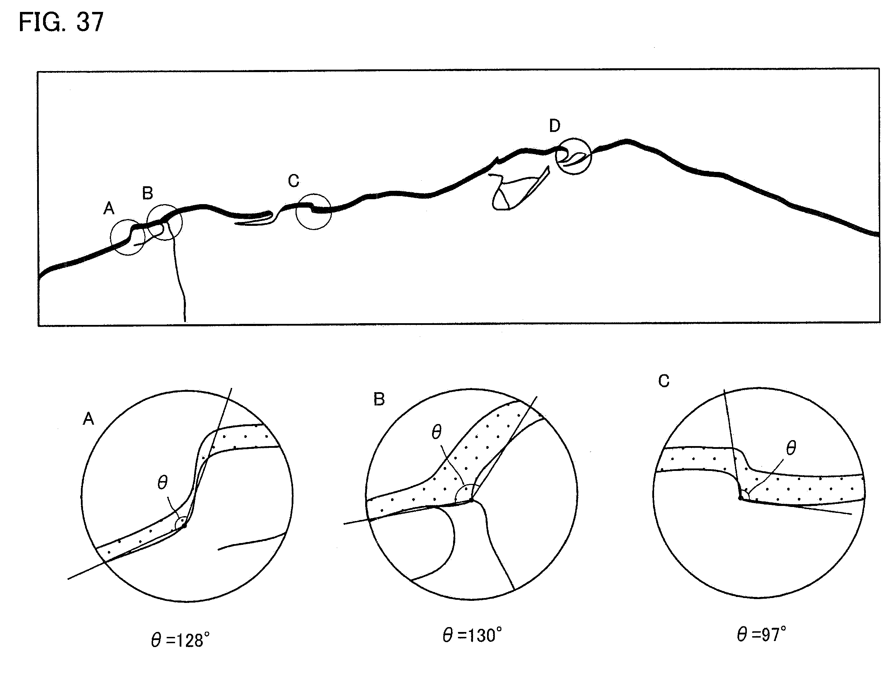

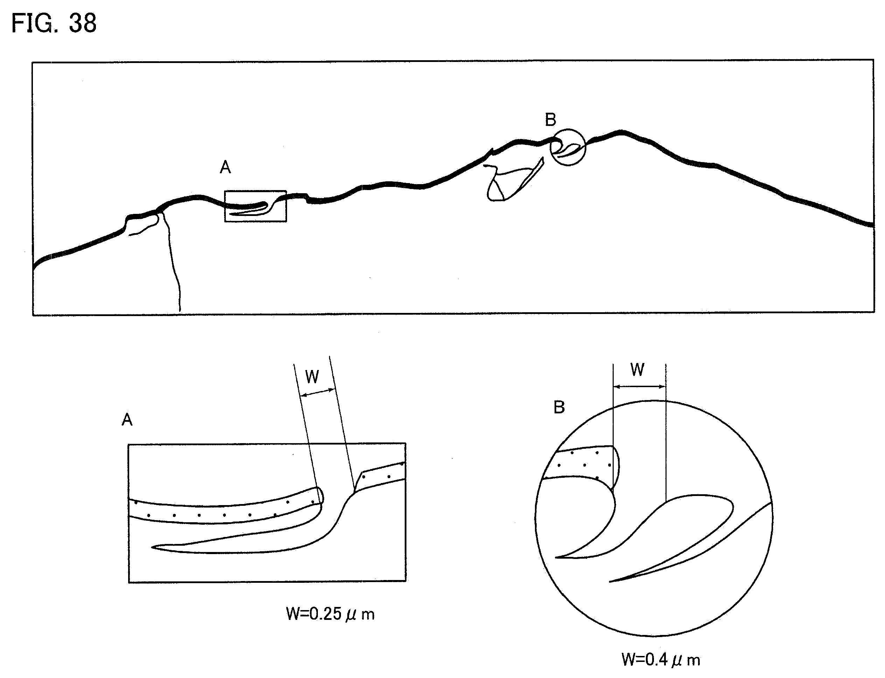

In the range shown in Figs. 36 to 38, three depressions 50 with the angle θ being 135 degrees or less were observed (see Fig. 37). Further, two large cracks 30 having an opening width W of 0.2 micrometer or more were observed (see Fig. 38).

That is, the total number of steep slope portions with the angle θ being 135 degrees or less and large cracks having an opening width of 0.2 micrometer or more was confirmed to be 5.

Similarly, also on the surface of the antireflection film 19, three depressions 50 with the angle θ being 135 degrees or less were observed, and two large cracks 30 having an opening width W of 0.2 micrometer or more were observed. That is, the total number of steep slope portions with the angle θ being 135 degrees or less and large cracks having an opening width of 0.2 micrometer or more was confirmed to be 5.

On the surface of the glass plate body 20, one glass surface high level-difference portion having an elevation difference of 0.7 micrometer or more per 0.3 micrometer at the surface of the glass plate body 20 itself was observed.

There exists one film surface high level-difference portion having an elevation difference of 0.7 micrometer or more per 0.3 micrometer at the surface of the antireflection film 19.

On the surface of the glass plate body 20, four glass surface high level-difference portions having an elevation difference of 0.3 micrometer or more per 0.3 micrometer at the surface of the glass plate body 20 itself were observed.

There existed four film surface high level-difference portions having an elevation difference of 0.3 micrometer or more per 0.3 micrometer at the surface of the antireflection film 19.

That is, on any part of the surface of the solar cell module produced by the conventional technology, the total number of steep slope portions with the angle θ being 135 degrees or less and large cracks having an opening width of 0.2 micrometer or more was 5 or more.

There exist a large number of glass surface high level-difference portions, only a few of which are filled with the antireflection film 19.

### LIST OF REFERENCE CHARACTERS

- 1: Solar cell module
- 3: Photoelectric conversion unit
- 19: Antireflection film
- 20: Glass plate body
- 27: Depression (steep slope portion)
- 28: Depression (overhang portion)
- 30: Large crack
- 40: Contour line
- 50: Depression (steep slope portion)

## Claims

1. A solar cell module comprising:
a glass plate body made of glass and having a macroscopically flat surface; and
a photoelectric conversion unit,
the solar cell module generating electricity in the photoelectric conversion unit by making light incident from a glass plate body side to a photoelectric conversion unit side,
wherein the surface of the glass plate body is provided with an antireflection film and is itself microscopically irregular, the surface of the glass plate body having:
a change point at which a slope on a contour line of the surface of the glass plate body changes steeply when a cross-section cutting through the glass plate body in a thickness direction is observed;
a steep slope portion in which the glass plate body itself is recessed and an angle formed by a one-side pseudo-straight line obtained by pseudo-leveling of the contour line within 0.7 micrometer on one side and an other-side pseudo-straight line obtained by pseudo-leveling of the contour line within 0.7 micrometer on another side with the change point as a boundary is 135 degrees or less; and
a large crack having an opening width of 0.2 micrometer or more,
some or all of the steep slope portion and some or all of the large crack of the surface of the glass plate body itself are filled with a substance that forms the antireflection film, and
a surface of the antireflection film has a contour line of a gentle curve, the surface of the antireflection film having a total number of less than 5 steep slope portions and large cracks per each 58-micrometer compartment range at the surface of the antireflection film.

2. A solar cell module comprising:
a glass plate body made of glass and having a macroscopically flat surface; and
a photoelectric conversion unit,
the solar cell module generating electricity in the photoelectric conversion unit by making light incident from a glass plate body side to a photoelectric conversion unit side,
wherein the surface of the glass plate body is provided with an antireflection film and is itself microscopically irregular, the surface of the glass plate body having:
a steep slope portion in which the glass plate body itself is recessed when a cross-section cutting through the glass plate body in a thickness direction is observed and an angle formed by a one-side pseudo-straight line obtained by pseudo-leveling of the contour line within 0.7 micrometer on one side and an other-side pseudo-straight line obtained by pseudo-leveling of the contour line within 0.7 micrometer on another side with an arbitrary point as a boundary is 135 degrees or less; and
a large crack having an opening width of 0.2 micrometer or more,
some or all of the steep slope portion and some or all of the large crack of the surface of the glass plate body itself are filled with a substance that forms the antireflection film, and
a surface of the antireflection film has a contour line of a gentle curve, the surface of the antireflection film having a total number of less than 5 steep slope portions and large cracks per each 58-micrometer compartment range at the surface of the antireflection film.

3. The solar cell module according to claim 1 or 2, wherein the surface of the glass plate body itself has an overhang portion in which the angle formed by the one-side pseudo-straight line obtained by pseudo-leveling of the contour line within 0.7 micrometer on one side and the other-side pseudo-straight line obtained by pseudo-leveling of the contour line within 0.7 micrometer on the other side with the change point or an arbitrary point as a boundary is 90 degrees or less,
some or all of the overhang portions of the surface of the glass plate body itself are filled with a substance that forms the antireflection film, and
the surface of the antireflection film has a contour line of a gentle curve, the surface of the antireflection film having a total number of less than 2 steep slope portions and large cracks per each 58-micrometer compartment range at the surface of the antireflection film.

4. A solar cell module comprising:
a glass plate body made of glass and having a macroscopically flat surface; and
a photoelectric conversion unit,
the solar cell module generating electricity in the photoelectric conversion unit by making light incident from a glass plate body side to a photoelectric conversion unit side,
wherein the surface of the glass plate body is provided with an antireflection film and is itself microscopically irregular, the surface of the glass plate body having:
a change point at which a slope on a contour line of the surface of the glass plate body changes steeply when a cross-section cutting through the glass plate body in a thickness direction thereof is observed;
a steep slope portion in which the glass plate body itself is recessed and an angle formed by a one-side pseudo-straight line obtained by pseudo-leveling of the contour line within 0.7 micrometer on one side and an other-side pseudo-straight line obtained by pseudo-leveling of the contour line within 0.7 micrometer on another side with the change point as a boundary is 135 degrees or less; and
a large crack having an opening width of 0.2 micrometer or more,
the surface of the glass plate body itself having a total number of less than 5 steep slope portions and the large cracks with per each 58-micrometer compartment range at the surface thereof, and
some or all of the steep slope portion is filled with a substance forming the antireflection film that has a contour line of a gentle curve.

5. A solar cell module comprising:
a glass plate body made of glass and having a macroscopically flat surface; and
a photoelectric conversion unit,
the solar cell module generating electricity in the photoelectric conversion unit by making light incident from a glass plate body side to a photoelectric conversion unit side,
wherein the surface of the glass plate body is provided with an antireflection film and is itself microscopically irregular, the surface of the glass plate body having:
a steep slope portion in which the glass plate body itself is recessed when a cross-section cutting through the glass plate body in a thickness direction thereof is observed and an angle formed by a one-side pseudo-straight line obtained by pseudo-leveling of the contour line within 0.7 micrometer on one side and an other-side pseudo-straight line obtained by pseudo-leveling of the contour line within 0.7 micrometer on another side with an arbitrary point as a boundary is 135 degrees or less; and
a large crack having an opening width of 0.2 micrometer or more,
the surface of the glass plate body itself having a total number of less than 5 steep slope portions and large cracks per each 58-micrometer compartment range at the surface thereof, and
some or all of the steep slope portions are filled with a substance forming the antireflection film that has a contour line of a gentle curve.

6. The solar cell module according to claim 4 or 5, wherein the surface of the glass plate body itself has an overhang portion in which the angle formed by the one-side pseudo-straight line obtained by pseudo-leveling of the contour line within 0.7 micrometer on one side and the other-side pseudo-straight line obtained by pseudo-leveling of the contour line within 0.7 micrometer on the other side with the change point or an arbitrary point as a boundary is 90 degrees or less,
the surface of the glass plate body itself having a total number of less than 2 steep slope portions and large cracks per each 58-micrometer compartment range at the surface thereof, and
some or all of the overhang portions of the surface of the glass plate body itself are filled with a substance that forms the antireflection film.

7. The solar cell module according to any one of claims 1 to 6, wherein an average value of the total number of the steep slope portions and the large cracks per each 58-micrometer compartment range is 0.5 or more and less than 5 at the surface of the antireflection film.

8. The solar cell module according to any one of claims 1 to 7, wherein an average value of the total number of the steep slope portions and the large cracks per each 58-micrometer compartment range is 0.5 or more and less than 5 at the surface of the glass plate body itself.

9. The solar cell module according to any one of claims 1 to 8, wherein a glass surface high level-difference portion having an elevation difference of 0.7 micrometer or more per 0.3 micrometer at the surface of the glass plate body itself is distributed with a number thereof being 3 or less per each 58-micrometer compartment range, and a film surface high level-difference portion having an elevation difference of 0.7 micrometer or more per 0.3 micrometer at the surface of the antireflection film is distributed with a number thereof being less than 1 per each 58-micrometer compartment range.

10. The solar cell module according to any one of claims 1 to 9, wherein a glass surface high level-difference portion having an elevation difference of 0.3 micrometer or more per 0.3 micrometer at the surface of the glass plate body itself is distributed with a number thereof being 7 or less per 58-micrometer compartment range, and a film surface high level-difference portion having an elevation difference of 0.3 micrometer or more per 0.3 micrometer at the surface of the antireflection film is distributed with a number thereof being less than 3 per 58-micrometer compartment range.

11. The solar cell module according to any one of claims 1 to 10, wherein the surface of the antireflection film has an arithmetic mean deviation of 0.4 micrometer to 2.0 micrometers.

12. A method for producing the solar cell module according to any one of claims 1 to 11, the method comprising:
a first roughening step of colliding solid particles to the surface of the glass plate body to roughen the surface of the glass plate body;
a second roughening step of colliding solid particles, which have a particle size smaller than that in the first roughening step, to the surface of the glass plate body after the first roughening step; and
an antireflection film forming step of applying a liquid antireflection film raw material to the surface of the glass plate body to form the antireflection film on the surface of the glass plate body.

13. A method for producing a solar cell module, the solar cell module comprising:
a glass plate body made of glass and having a macroscopically flat surface; and
a photoelectric conversion unit,
the solar cell module generating electricity in the photoelectric conversion unit by making light incident from the glass plate body side to the photoelectric conversion unit side,
the method comprising:
a first roughening step of colliding solid particles to the surface of the glass plate body to roughen the surface of the glass plate body;
a second roughening step of colliding solid particles, which have a particle size smaller than that in the first roughening step, to the surface of the glass plate body after the first roughening step; and
an antireflection film forming step of applying a liquid antireflection film raw material to the surface of the glass plate body to form an antireflection film on the surface of the glass plate body.
